# EUROPEAN PATENT SPECIFICATION

(11) **EP 1 862 487 B1**
(45) Date of publication and mention of the grant of the patent: **07.10.2009**
(21) Application number: 07109114.4
(22) Date of filing: 29.05.2007
(51) Int. Cl.: C08G 61/12, H01B 1/12, H01G 9/00

(54) **Electrically conductive polymers and method of making electrically conductive polymers**
Elektrisch leitende Polymere und Verfahren zur Herstellung elektrisch leitender Polymere
Polymères électriquement conducteurs et leurs procédés de fabrication

(30) Priority: 02.06.2006 US 446000
(43) Date of publication of application: 05.12.2007
(73) Proprietor: Air Products and Chemicals, Inc., Allentown, PA 18195-1501 (US)
(72) Inventor: Zahn, Steffen, Pennsburg, PA 18073 (US); Ford, Michael Edward, Trexlertown, PA 18087 (US)
(74) Representative: Westendorp | Sommer

(56) References cited:
- EP-A2- 0 339 340
- DE-A1- 3 926 690
- GB-A- 608 969

## Description

### CROSS-REFERENCE TO RELATED APPLICATIONS

The subject matter of the instant invention is related to copending and commonly assigned Patent Application No. 11/446,075, filed on even date herewith, and entitled "HETEROCYCLIC FUSED IMIDAZOLONE, DIOXOLONE, IMIDAZOLETHIONE AND DIOXOLETHIONE MONOMERS". The disclosure of which is hereby incorporated by reference.

### BACKGROUND OF THE INVENTION

The present invention is directed to compositions of matter, more particularly, electrically conductive polymers comprising polymerized heterocyclic fused ring monomers, methods of producing such compositions of matter, and to applications utilizing such compositions of matter. The compositions of matter according to this invention can be utilized in a variety of industrial applications including electrochromic displays, electrolytic capacitors optically transparent electrodes and antistatic coatings.

Polymers formed from thiophene and substituted thiophene monomers, which possess relatively low band gaps (Eg), demonstrate measurable electrical conductivity. Such polymers are often referred to as intrinsically conducting polymers. The term, band gap (Eg), refers to the energy difference between electronic energy levels called the conduction band and the valence band. The band gap exhibited by a given polymer depends upon a variety of factors including the structure of the monomer making up the polymer. For example, polythiophene demonstrates a band gap of 2.1 eV, poly (2-decylthieno[3,4-b] thiophene) demonstrates a band gap of 0.92 eV and poly(2-phenylthieno[3,4-b]thiophene) demonstrates a band gap of 0.85 eV.

intrinsically conducting polymers consisting solely of aromatic repeating units in the polymer backbone are typically not soluble in water. Consequently, such polymers are typically processed using organic solvents. Several methods have been employed to increase the solubility of intrinsically conducting polymers in various organic solvents. Such methods include (1) forming a derivative of the monomer to increase the solubility of the side chains of the monomer in a given organic solvent; (2) modifying the polymer backbone by employing oligomeric conjugated systems and flexible spacers; and (3) using charge compensating dopants.

United States Patent 5,300,575 (the '575 Patent) discloses dispersions of polythiophenes which are suitable for use as antistatic coatings for plastic moldings. These polythiophenes are prepared by polymerizing the corresponding monomer in the presence of oxidizing agents typically used for the oxidative polymerization of pyrrole and/or with oxygen or air in the presence of a polyanion. The polythiophenes of the '575 Patent have a relatively low Eg of 1.7 eV compared to poly(thiophene) which has an Eg of 2.1 eV.

The polythiophenes of the '575 Patent are typically prepared by polymerizing 3,4-ethylenedioxythiophene in the presence of poly(styrene sulfonic acid). The resulting linear polymer is purified using both anion and cation exchange resins wherein poly(styrene sulfonate) serves as a charge compensating dopant. The resulting polymer forms a colloidal dispersion in water because poly(styrene sulfonate) is soluble in water and demonstrates a strong ionic interaction with the cationic polymeric backbone.

The disclosure of the previously identified patent is hereby incorporated by reference.

There is a need in this art for intrinsically conducting polymers which exhibit useful bandgaps for industrial applications, which can be readily dispersed in water and which are stable in solution to afford a useful shelf life.

### BRIEF SUMMARY OF THE INVENTION

The present invention comprises compounds, compositions of matter formed from polymerized units of heterocyclic fused ring monomer units and products including the inventive polymer. In one embodiment of the present invention, the invention provides a polymer having a repeating unit having formula P1, as follows: 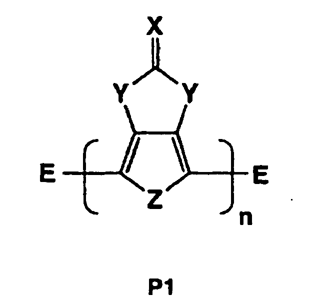 wherein n is an integer greater than 4; Z is Se, S, O, NR₁, or PR₁, where R₁ is hydrogen, alkylaryl, arylalkyl, or aryl; Y is independently selected from NH, O, C(R)₂, N(R)₂ and S; X is O, S, Se or NH and E is independently selected from functional or non-functional end-groups. R is a substituted or unsubstituted C1-C4 alkyl group. E is independently selected from functional and non-functional end-groups. The repeating structures according to the present invention may be substantially identical, forming a homopolymer, or may have Z, Y, and X independently selected for each unit, resulting in a copolymeric compound. The repeating unit may be terminated in any suitable manner and may include functional or non-functional end groups. Examples of suitable terminations comprise hydrogen, deuterium, vinyl, phenyl, acetylene, nitrile, 2-thienyl, or 3-thienyl groups.

A copolymer according to the present invention may comprise a copolymer having a repeating unit having formula C1, as follows: 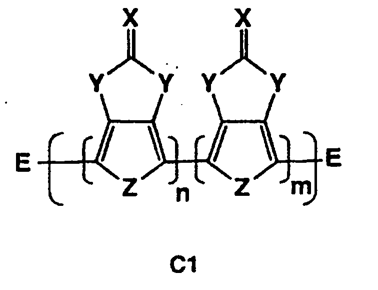 wherein n and m are independently selected integers having a total n+m of greater than 4 and X, Y, Z and E are the same as the groups defined for formula P1. The n-unit substructure and m-unit substructure of the copolymer may be arranged in any fashion making up the copolymer including, but not limited to random copolymers, graft copolymers, block copolymers, and dendritic structures.

Another copolymer according to the present invention may comprise a copolymer having a repeating unit having formula C2, as follows: 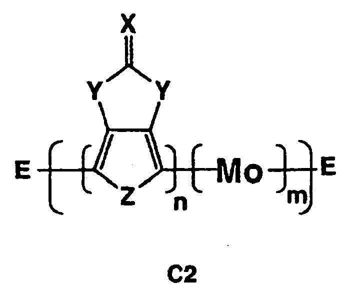 wherein n and m are independently selected integers having a total n+m of greater than 4 and X, Y, Z and E are the same as the groups defined for formula P1. The n-unit substructure and m-unit substructure of the copolymer may be arranged in any fashion making up the copolymer including, but not limited to random copolymers, graft copolymers, block copolymers, and dendritic structures. Mo in the formula C2 structure may be any electroactive or non-electroactive monomer copolymerizable with the n-unit substructure of formula C2 including, but not limited to thieno[3,4-b]thiophenes, and substituted thiophenes.

Useful substituted thieno[3,4-b]thiophenes that can be incorporated into the polymers of the present invention to form a copolymer are represented by the formula: 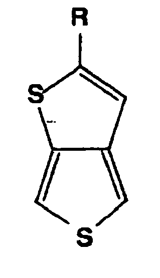 wherein R = C₁ to C₁₂ primary, secondary or tertiary alkyl group, phenyl, substituted phenyl, cyclohexyl, naphthalenic, hydroxyl, alkyl ether, carboxylic acid, carboxylic ester and a sulfonic acid.

Other substituted thiophenes that can be incorporated into the polymers of the present invention to form a copolymer are represented by the formula: 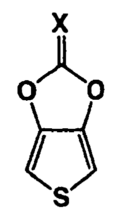 where X denotes S, O, Se, or NH.

Further substituted thiophenes that can be incorporated into the polymers of the present invention to form a copolymer are represented by the formula: 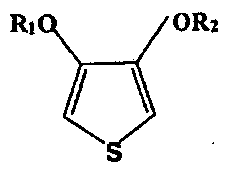 wherein R₁ and R₂ are independently selected from the group consisting of H, C1-C4 alkyl groups, 1,2 cyclohexylene radical, phenyl substituted phenyl and the like.

The polymers and copolymers of the present invention may comprise polymerized units of heterocyclic fused ring structures comprising dioxolamine, imidazolone, dioxolone, imidazolethione or dioxolethione structures. One useful polymer comprises or consists essentially of poly(1 H-thieno[3,4-d]imidazol-2(3H)-one). The polymers of this invention may include copolymers further comprising polymerized units of an electroactive monomer. Useful electroactive monomers can comprise at least one member selected from the group consisting of thiophene, thieno[3,4-b]thiophene, thieno[3,2-b]thiophene, substituted thiophenes, substituted thieno[3,4-b]thiophenes, substituted thieno[3,2-b]thiophene, dithieno[3,4-b:3',4'-d]thiophene, pyrrole, bithiophene, substituted pyrroles, phenylene, substituted phenylenes, naphthalene, substituted naphthalenes, biphenyl and terphenyl, substituted terphenyl, phenylene vinylene and substituted phenylene vinylene. In addition to electroactive monomers, the copolymers according to the present invention may include polymerized units of a non-electroactive monomers.

The polymers of the present invention can comprise polymerized units of 1H-thieno[3,4-d]imidazol-2(3H)-one and may further comprise an oligomer comprising 1 H-thieno[3,4-d]imidazol-2(3H)-one which is end group functionalized, polymerized units of 3,4-ethylenedioxythiophene and polymerized units of pyrrole.

The polymers of this invention can be doped with p-dopants or n-dopants to modify the electrical properties of such polymers.

Another embodiment of the invention relates to polythiophenes and polyselenophenes formed from monomer structural units formula M1, as follows:

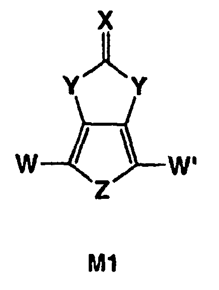

Z is Se, S, O, NR₁, or PR₁, where R₁ is hydrogen, alkylaryl, arylalkyl, or aryl; Y is independently selected from NH, O, C(R)₂, N(R)₂ and S; X is O, S, Se or NH. R is a substituted or unsubstituted C1-C4 alkyl group. W and W' are H, halogen atoms, e.g., F, Cl, Br, and I, metallorganics, e.g., MgCl, MgBr, Mgl, Sn(R₂)₃, where R₂ is C₁₋₆ alkyl or C₁₋₆ alkyl ether, boronic acid, boronic ester, vinyl units, e.g., -CH=CHR₃ where R₃ is H or C₁₋₆ alkyl, ether, i.e., -OC₁₋₆, alkyl, esters, i.e.,-COOC₁₋₆ alkyl, -S-COR₄ and -COR₄ where R₄ is H or C₁₋₆ alkyl, -C=CH, and polymerizable aromatic rings such as phenyl, naphthalene, pyrrole, and thiophene.

Another embodiment of the present invention comprises a process for preparing electrically conductive polymers and copolymers. The polymerization reaction of the monomers described above may be achieved by using one or more reaction mechanisms. Reactions suitable for use with the present invention include: 1) aqueous phase/oxidant polymerization, 2) organic solvent phase/oxidant polymerization, 3) metal catalyst polymerization, and 4) electrochemical polymerization. One embodiment of the present invention includes polymerized units of 1 H-thieno[3,4-d]imidazol-2(3H)-one obtained by a process comprising the steps of reacting 1 H-thieno[3,4-d]imidazol-2(3H)-one in the presence of water, at least one polyanion and at least one oxidant under reactions conditions sufficient to form the polymer comprising polymerized units of 1H-thieno[3,4-d]imidazol-2(3H)-one. Polyanions for use in the aqueous phase reaction may comprise at least one member selected from the group consisting of polyacrylic acid, polymethacrylic acid, polysulfonic acid (e.g., available commercially as Nafion®), polymaleic acid, polystyrene sulfonic acid and polyvinyl sulfonic acid. Oxidants for use in the aqueous phase and the organic phase reaction may comprise at least one member selected from the group consisting of FeCl₃, Fe(ClO₄)₃, H₂O₂, K₂Cr₂O₇, ammonium persulfate, potassium permanganate, copper tetrafluoroborate, iodine, air and oxygen.

An advantage of the polymer compositions of the present invention is that, in one embodiment of the invention, the composition may be easily prepared, readily storable and reduce or eliminate environmental problems associated with use of dispersions formed from organic solvents. The inventive polymers and methods for making the polymers can be substantially free of solvents. By "substantially free" of solvents it is mean that less than about1% to about 15% of ether, alcohol, or chloroalkane compounds are present. Water-borne dispersions of the compositions of matter of this invention (e.g., dispersions that are substantially free of solvents), can be cast to provide uniform, thin films that possess utility in numerous applications including electrochromic displays, optically transparent electrodes, antistatic coatings, among uses. A typical dispersion of the invention comprises about 45 to about 99 % water (e.g., deionized water), about 1 % to about 10 % polymer, and additives 0.1 to 50 % such as surfactants, 5 to 60% monomeric or polymeric anions (such as the anions of camphorsulfonic acid or polysulfonic acid [Nafion®]), and 0 to 60 % alcohols or polyalcohols such as ethanol, 2-methoxyethanol, or sorbitol or DMSO.

Another advantage of the present invention is that the polymerization reactions take place with desirable alignment of the monomer components during the polymerization reaction, providing for intrinsically conducting polymers having desirable electrical properties, including useful bandgaps. The inventive polymers can have an electrical conductivity ranging from about 10⁻⁵ to about 1000 S/cm. Examples of useful band gaps that can be obtained by the instant invention range from about 1.3 eV to about 3.3 eV.

Still another advantage of the present invention is that the polymers of the present invention may be formed into a variety of products including, but not limited to, hole injection materials, charge transport materials, semiconductors, and/or conductors, in optical, electrooptical or electronic devices, polymeric light emitting diodes (i.e., PLED), electroluminescent devices, organic field effect transistors (i.e., FET or OFET), flat panel display applications (e.g., LCD's), radio frequency identification (i.e., RFID) tags, printed electronics, ultracapacitors, organic phatavoltaics (i.e., OPV), sensors, lasers, small molecule or polymer based memory devices, electrolytic capacitors, anticorrosion coatings, or as hydrogen storage materials

Other features and advantages of the present invention will be apparent from the following more detailed description of certain embodiments.

### DETAILED DESCRIPTION OF THE INVENTION

This invention comprises compounds and compositions of matter which include intrinsically conducting polymers including polymerized units of fused heterocyclic ring structure monomers. Polymer, as defined herein, shall mean a compound and composition of matter having at least four polymerized units of heterocyclic fused monomer structure repeating units. These compounds and compositions of matter can be prepared to exhibit a variety of properties desired for numerous end-use applications.

More particularly, such compositions of matter include polymers, copolymers and oligomers comprising polymerized units having formula P1, as follows: 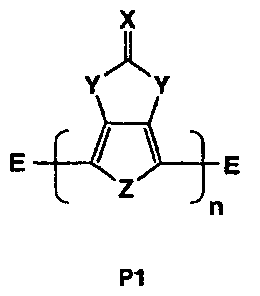 wherein n is an integer greater than 4; Z is Se, S, O, NR₁, or PR₁, where R₁ is hydrogen, alkylaryl, arylalkyl, or aryl; Y is independently selected from NH, O, C(R)₂, N(R)₂ and S; X is O, S, Se or NH and E is independently selected from functional or non-functional end-groups. R is a substituted or unsubstituted C1-C4 alkyl group; E is independently selected from functional and non-functional end-groups.

Copolymer, as defined herein, shall mean a composition of matter having at least four polymerized units of heterocyclic fused monomer structure repeating units and polymerized monomers different than the heterocyclic fused monomer structure.

The term, substrate, as defined herein, shall mean a solid material (which may be flexible or rigid) suitable for deposition of the compositions of matter according to this invention. Substrates can be formed of materials including, but not limited to glass, organic polymers such as poly(ethylene terephthalate), poly(ethylene naphthalenate), poly(ethylene), poly(propylene), or poly(styrene), plastic, silicon, minerals, semiconducting materials, ceramics, metals such as tantalum, aluminum, or niobium, oxide surfaces of the foregoing metals, among others. The substrate may be inherently conductive. The substrate may also be precoated or pretreated to have a film or layer that contacts the inventive polymer.

The term, electroactive monomer, as defined herein, shall mean a monomer which is capable of polymerization or copolymerization resulting in a polymer having electrically conductive properties such as electrical conductivity, semiconductivity, electroluminescence, electrochromicity or photovoltaic properties.

The term, non-electroactive monomer, as defined herein, shall mean a monomer which is capable of polymerization or copolymerization which does not exhibit the properties set forth under the definition of electroactive monomer.

The term, band gap, as defined herein, shall mean the energy difference between electronic energy levels called the conduction band and the valence band.

The term, substituted, as defined herein, as used with respect to a composition of matter, shall mean an electron-rich or electron deficient group appended to such composition of matter, Useful substituents include, but are not limited to, H, hydroxyl, aryl, phenyl, cycloalkyl, alkyl, halogen, alkoxy, alkylthio, perfluoroalkyl, perfluoroaryl, pyridyl, cyano, thiocyanato, nitro, amino, alkylamino, acyl, sulfoxyl, sulfonyl, amido, and carbamoyl.

The term, aryl, as defined herein, shall mean a compound having the ring structure characteristic of benzene, naphthalene, phenanthrene, anthracene, etc. (e.g., the 6-carbon ring of benzene or the condensed 6-carbon rings of the other aromatic derivatives). For example, an aryl group may be phenyl (e.g., C₆H₅) or naphthyl (e.g., C₁₀H₇). The aryl group, while a substituent can itself have additional substituents (e.g. the substituents disclosed under this definition).

The term, alkyl, as defined herein, shall mean a paraffinic hydrocarbon group which may be derived from an alkane by dropping one hydrogen from the formula. Examples are methyl (CH₃--), ethyl C₂H₅--), propyl (CH₃CH₂CH₂--), isopropyl ((CH₃)₂CH--).

The term, halogen, as defined herein, shall mean one of the electronegative elements of group VIIA of the periodic table (fluorine, chlorine, bromine and iodine).

The term, perfluoroalkyl, as defined herein, shall mean an alkyl group in which every hydrogen atom is replaced by a fluorine atom.

The term, perfluoroaryl, as defined herein, shall mean an aryl group in which every hydrogen atom is replaced by a fluorine atom.

The term, sulfoxyl, as defined herein, shall mean a group of composition RS(O)- where R is an alkyl, aryl, cycloalkyl, perfluoroalkyl or perfluoroaryl group. Examples include, but are not limited to methylsulfoxyl, phenylsulfoxyl, and the like.

The term, sulfonyl, as defined herein, shall mean a group of composition RS(O)₂- where R is an alkyl, aryl, cycloalkyl, perfluoroalkyl, or perfluoroaryl group. Examples include, but are not limited to methylsulfonyl, phenylsulfonyl, p-toluenesulfonyl, and the like.

The term, acyl, as defined herein, shall mean an organic acid group in which the -hydroxyl of the carboxyl group is replaced by another substituent to form the structure R(C=O)-. Examples include, but are not limited to acetyl, benzoyl, and the like.

Heterocyclic fused monomer compounds can be used for forming the polymer according to an embodiment of the present invention. Examples of suitable heterocyclic fused ring monomers can comprise at least one of thieno[3,4-d]-1,3-dioxolan-2-imine (1a), thieno[3,4-d]-1,3-dioxolan-2-one (1b), selenolo(3,4-d)-1,3-dinxolan-2-one (1c), 1H-selenolo[3,4-d]imidazol-2(3H)-one (1d), and 1H-thieno[3,4-d]imidazol-2(3H)-one (1e) and the thiocarbonyl compounds thieno[3,4-d]-1,3-dioxolan-2-thione (1f), selenolo[3,4-d]-1,3-dioxolan-2-thione (1g), 1 H-selenolo[3,4-d]imidazol-2(3H)-thione (1 h), and 1 H- thieno[3,4-d]imidazol-2(3H)-thione (1i) all shown by the following structures:

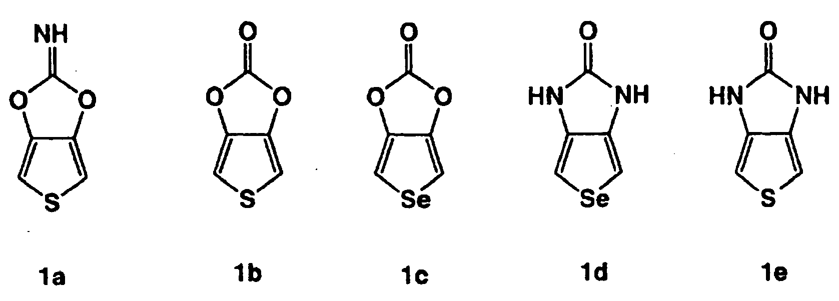

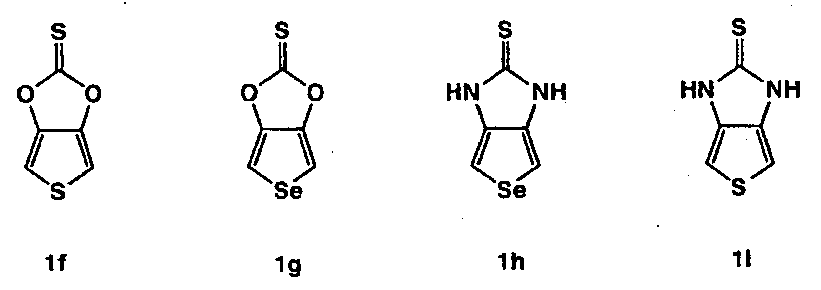

Any of the above monomer compounds may be used in the process of the present invention to form electrically conductive polymers. Monomers utilized in the polymerization reaction may be the same, such as in homopolymerization, or may be different, such as in copolymerization. Monomers suitable for using in the instant invention can also be found in previously identified copending and commonly assigned U.S. Application No. filed on even date herewith.

A monomer useful in one embodiment of the present invention comprises 1 H-thieno[3,4-d]imidazol-2(3H)-one, which includes two alpha positions adjacent to the respective sulfur atom of the monomer. Polymers according to this embodiment of the invention may be propagated from the 1 H-thieno[3,4-d]imidazol-2(3H)-one to form polymerized units by effecting reaction at the alpha positions (represented by an asterisk) of the monomer depicted in formula M2, as follows: 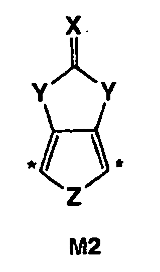 X, Y and Z are the groups describe above with respect to formula P1.

The reactive alpha positions of the M2 monomer can react with additional M1 monomers to form a homopolymer of polymerized units or can react with one or more additional electroactive monomers or non-electroactive monomers to form copolymers, including random copolymers, graft copolymers, block copolymers, and dendritic structures.

One embodiment of the present invention comprises a homopolymer formed by polymerizing 1 H-thieno[3,4-d]imidazol-2(3H)-one. 1 H-thieno[3,4-d]imidazol-2(3H)-one of the resulting polymer constitutes a polymerizable unit. The homopolymer is referred to as poly(1 H-thieno[3,4-d]imidazol-2(3H)-one).

Electroactive monomers suitable for incorporation into the polymers of this invention to form copolymers include those which exhibit electroactivity and can comprise at least one member selected from the group consisting of thiophene, thieno[3,4-b]thiophene, thieno[3,2-b]thiophene, substituted thiophenes, substituted thieno[3,4-b]thiophenes, substituted thieno[3,2-b]thiophene, dithieno[3,4-b:3',4'-d]thiophene, pyrrole, bithiophene, substituted pyrroles, phenylene, substituted phenylenes, naphthalene, substituted naphthalenes, biphenyl and terphenyl, substituted terphenyl, phenylene vinylene and substituted phenylene vinylene.

Suitable substituted thieno[3,4-b] thiophenes for incorporation into the polymers of the present invention to form copolymers are represented by the formula; 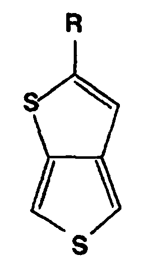 wherein R = C₁ to C₁₂ primary, secondary or tertiary alkyl groups, phenyl and substituted phenyl groups, cyclohexyl, naphthalenic, hydroxyl, alkyl ether, carboxylic acids, esters and sulfonic acid groups.

Suitable substituted thiophenes for incorporation into the polymers of the present invention to form copolymers include the following substituted thiophenes described in United States Patent 4,959,430, which is herein incorporated by reference in its entirety: 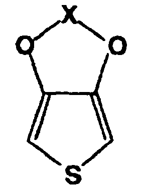 wherein x denotes a substituted C₁-C₄ alkyl group, a C₁-C₁₂alkyl or phenyl substituted 1,2 ethylene radical or a 1,2 cyclohexylene radical. Optionally, the alkyl or phenyl groups can be further substituted with functional groups such as hydroxyls, ethers and the like.

Additional substituted thiophenes for incorporation into the polymers of the present invention to form copolymers can comprise the following substituted thiophenes disclosed in United States Patent 4,910,645, which is herein incorporated by reference in its entirety: 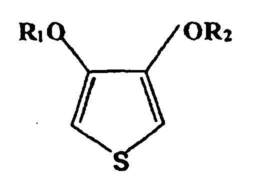 wherein R₁ and R₂ are independently selected from the group consisting of H, C₁-C₄alkyl groups, 1,2 cyclohexylene radical and phenyl substituted phenyl.

The compositions of matter according to this invention also comprise oligomers comprising heterocyclic fused ring monomers which are endgroup functionalized and incorporated into either block copolymers or coupled with difunctional reactants (as an example hydroxyl endgroups could be coupled with diisocyanates or acid chlorides). Such oligomers provide a convenient method for controlling the conjugation length of the compositions of matter of this invention. The conjugation length in the oligomeric structure can be varied to achieve desired properties for a variety of applications. For example, the conjugation length can be increased in order to obtain higher transparency, or decreased in order to obtain lower formulation viscosities.

The compositions of matter of the present invention may also include repeating units of non-electroactive monomers which are capable of being polymerized with 1 H-thieno[3,4-d]imidazol-2(3H)-one. For most applications, the non-electroactive monomer employed as a repeating unit should not adversely affect the electroactive properties of the resulting composition of matter.

The compositions of matter of this invention can be utilized as dispersions by combining a desired polymer (including copolymers and oligomers) with water, and a mixture of at least one water-miscible organic solvent or at least one organic solvent. Dispersions containing the compositions of matter according to this invention can be applied via processes including ink jet printing, screen printing, roll to roll printing processes, spin coating, meniscus and dip coating, spray coating, brush coating, doctor blade application, curtain casting and the like. The amount of polymer (including copolymers and oligomers) to be incorporated into the solution or dispersion may vary depending upon a variety of factors including the molecular weight of the composition of matter and the end-use application. The actual amount of composition of matter to be introduced into the dispersion is readily determined without undue experimentation.

The dispersed films may be dried by techniques including evaporation to remove the solvent to provide the desired film. Drying may be effected at room temperature or any temperature which does not adversely affect the intended properties of the resulting film. However, to obtain higher processing speeds, the film can be dried at elevated temperatures provided that such temperatures do not adversely affect the properties of the resulting film (e.g., dried at a temperature of about room temperature to about 200C). The thickness of the film normally ranges from about 50 nm to about 25 microns.

The compositions of matter of this invention can be utilized in a variety of conventional applications including antistatic coatings, electrically conductive coatings, electrochromic devices, photovoltaic devices, light emitting diodes, flat panel displays, photoimageable circuits, printable circuits, thin film transistor devices, batteries, electrical switches, capacitor coatings, corrosion resistant coatings, electromagnetic shielding, sensors, LED lighting and other optoelectronics. (Optoelectronics is a field of technology that combines the physics of light with electricity. Optoelectronics encompasses the study, design and manufacture of hardware devices that convert electrical signals into photon signals and vice versa. Any device that operates as an electrical-to-optical or optical-to-electrical transducer is considered an optoelectronic device.) The electrical conductivity of the compositions of matter according to the present invention can be readily modified, if necessary, to meet the requirements of any of the previously mentioned applications by doping these compositions of matter with conventional acidic dopants (p-dopants) and basic dopants (n-dopants).

Suitable p-dopants can comprise at least one mineral acid such as HCl, HNO₃, H₂SO₄, H₃PO₄, HBr, Hl; organic sulfonic acids such as dodecyl benzene sulfonic acid, lauryl sulfonic acid, camphor sulfonic acid, organic acid dyes, methane sulfonic acid, toluene sulfonic acid, polymeric sulfonic acids such as poly(styrene sulfonic acid) and copolymers; carboxylic acids such as acetic acid, propionic acid, butyric acid, hexanoic acid, adipic acid, azelaic acid, oxalic acid, and polymeric polycarboxylic acids such as poly(acrylic acid) poly(maleic acid), poly(methacrylic acid) and copolymers containing these acids. Mixed dopants such as mineral acids/ organic acids can also be utilized to impart desired electroactive character to the compositions of matter of this invention.

While p-doping can be employed, the compositions of matter according to this invention can be n-doped with conventional basic dopants including but not limited to Na, K, Li and Ca. Other suitable dopants can comprise l₂, (PF₆)⁻, (SbF₆)⁻, and FeCl₃. The amount of dopant can comprise about 1 % by weight to about 98% by weight of the composition, or an amount sufficient to obtain at least 1% doping.

The compositions of matter of this invention are well suited for use in fabricating certain components of light emitting diodes (LEDs). LEDs typically possess numerous layers including a substrate, and indium tin oxide (ITO) anode, a hole injection layer, a hole transport layer, a light emitting layer, an electron transport layer, an electron injection layer and a cathode. The p-doped compositions of matter of this invention are particularly suited toward replacing the indium tin oxide anode of the LED. The p-doped compositions of matter of this invention are also particularly suited toward use as the hole injection layer of the LED. Undoped compositions of matter of this invention can be utilized in the hole transport layer, the light emitting layer and/or the electron transport layer of the LED.

Admixtures of the compositions of matter of this invention with other electroactive materials such as laser dyes, other electroactive polymers, hole transport or electron transport materials including electroactive organometallic compounds are also embodied in this invention.

The compositions of matter of this invention can also be utilized to prepare optically transparent conductive coatings for use in optically transparent electrodes, transparent conductive adhesives, stealth coatings, transparent EMF shielding, touch screens, flat screen displays, flat antennas for mobile applications, transparent capacitor plates, and the like. Additional applications for polymers according to the present invention may include, but are not limited to, hole injection materials, charge transport materials, semiconductors, and/or conductors, in optical, electrooptical or electronic devices, polymeric light emitting diodes (i.e., PLED), electroluminescent devices, organic field effect transistors (i.e., FET or OFET), flat panel display applications (e.g., LCD's), radio frequency identification (i.e., RFID) tags, printed electronics, ultracapacitors, organic photovoltaics (i.e., OPV), sensors, lasers, small molecule or polymer based memory devices, electrolytic capacitors or as hydrogen storage materials.

Photovoltaic devices have specific similarities to LEDs and are likewise capable of fabrication using the compositions of the present invention. Instead of electrical voltage placed across the device to produce light for the LED device, the input of light (e.g. sunlight) produces a voltage difference across the device to produce an electric current. The layers of the LED and photovoltaic devices are similar but not equivalent. Light harvesting organics or polymers comprise an intermediate layer with hole transport/electron transport layers optionally placed between the anode and cathode. The compositions of matter of this invention can be utilized as the anode and hole injection layers (doped) or in the light harvesting layers (undoped).

The compositions of matter according to this invention can be utilized in fabricating electrochromic devices which permit or prevent the transmission of light through transparent substrates by application of a voltage across conventional substrates known in the art. Other uses for the compositions of matter according to the present invention include electromagnetic shielding and dimmable mirrors.

Doped compositions of matter according to this invention can be utilized as antistatic coatings applied from water-borne or organic solvent-borne solutions or dispersions to substrates enumerated under the definition section. Such antistatic coatings can include admixtures with other polymers including emulsions to achieve a balance of conductivity and film properties such as adhesion to the appropriate substrate. The compositions of matter of this invention can also be utilized as coatings or additives to various articles of commerce to render the article conductive including the various substrates noted above for antistatic coatings and electroplating processes, printable circuits, photoimageable circuits, semiconductor devices and the like.

While certain embodiments of this invention involves use of the compositions of matter as transparent/conductive materials, conductive nontransparent coatings based on the compositions of matter of this invention are also believed to have utility in specific applications where transparency is not important but electrical conductivity is important. Certain applications such as antistatic coatings may require pigmentation which will result in loss of transparency as well as various conductive paint applications. Printed circuits employing these materials will also generally not require transparency.

One embodiment of the invention relates to the use of certain polythiophenes and polyselenophenes (formula P1) as solid electrolyte in electrolyte capacitors, and to electrolyte capacitors which contain these polythiophenes and polyselenophenes as solid electrolytes.

Another embodiment of the invention relates to electrolyte capacitors which contain, as solid electrolytes, the polymer built up from the structural units of the formula P1. Solid electrolyte capacitors of this type can have the following structure
a) 1 st layer:
   Foil of an oxidizable metal, for example aluminum, niobium or tantalum;
b) 2nd layer:
   Oxide layer of the metal formed upon the metal foil;
c) 3rd layer:
   Polymer formed upon the metal oxide layer and built up from structural units of the formula M1; and, if appropriate 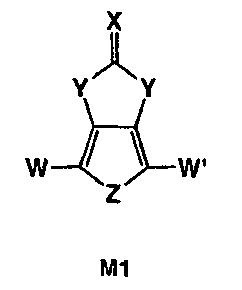 wherein Z is Se, S, O, NR₁, or PR₁, where R₁ is hydrogen, alkylaryl, arylalkyl, or aryl; Y is independently selected from NH, O, C(R)₂, N(R)₂ and S; X is O, S, Se or NH. R is a substituted or unsubstituted C1-C4 alkyl group. W and W' are H, halogen atoms, e.g., F, Cl, Br, and I, metallorganics, e.g., MgCl, MgBr, Mgl, Sn(R₂)₃, where R₂ is C₁₋₆ alkyl or C₁₋₆ alkyl ether, boronic acid, boronic ester, vinyl units, e.g., -CH=CHR₃ where R₃ is H or C₁₋₆ alkyl, ether, i.e., -OC₁₋₆ alkyl, esters, i.e., -COOC₁₋₆ alkyl, -S-COR₄ and -COR₄ where R₄ is H or C₁₋₆ alkyl, -C≡CH, and polymerizable aromatic rings such as phenyl, naphthalene, pyrrole, and thiophene.
d) 4th layer:
   Contact, for example, formed upon the polymer and comprising a thin layer of substances which are good conductors of the electrical current, such as conductive silver, copper or paint filled with carbon black.

While the above capacitor has been described with respect to polymer formula P1, copolymers may also be used. The present invention can comprise polythiophenes obtainable by oxidative polymerization of specific thiophenes which are particularly suitable as solid electrolytes for electrolyte capacitors. These specific polythiophenes can be applied and adhered, without impacting their conductivity, to the metal foils used as anodes in electrolyte capacitors, and produce capacitors which are distinguished by good electrical properties, for example a high, substantially frequency- independent capacity, and furthermore by low dielectric losses and low leakage currents While the inventive compounds can be employed in any suitable structure, one suitable structure is disclosed in US Patent No. 4,910,645; hereby incorporated by reference

The polythiophenes and polyselenophenes to be used according to the invention may be produced directly on the side of a metal foil that is coated with an oxide coating and used as an anode. The oxide coating can comprise oxides of tantalum, niobium, or aluminum. The anode can comprise a foil such as foils made from aluminum, niobium or tantalum. The polythiophenes and polyselenophenes can be produced in situ on the oxide coated film by oxidative polymerization of monomers of the present invention. The foil can be coated by applying a monomer, such as 1 H-thieno[3,4-d]imidazol-2(3H)-one, along with an oxidant, typically in the form of solutions, either separately one after the other or, if desired, together onto the oxide coated side of the metal foil. The oxidative polymerization, if appropriate, is completed on the oxide coated film. In some cases, the polymerization is enhanced by heating the solution (e.g., to a temperature of about 30C to about 150C).

Additives such as at least one member selected from the group consisting of ethylene glycol, diethylene glycol, mannitol, propylene 1,3-glycol, butane 1,4-glycol, N-methyl pyrrolidone, sorbitol, glycerol, propylene carbonate and other appropriate high boiling organics may be added to dispersions of the compositions of matter of this invention to improve conductivity.

Additional additives can comprise at least one conductive filler such as particulate copper, silver, nickel, aluminum, carbon black and the like. Non-conductive fillers such as talc, mica, wollastonite, silica, clay, TiO₂, dyes, pigments and the like can also be added to the dispersions to promote specific properties such as increased modulus, surface hardness, surface color and the like.

The dispersions of the compositions of matter of this invention may also comprise antioxidants, UV stabilizers and surfactants when required for specific applications. Surfactants are typically added to the dispersions to control stability, surface tension, and surface wettability. One useful surfactant comprises acetylenic diols. Viscosity modifiers (such as associative thickeners) can also be added to such dispersions to adjust viscosity for specific end uses.

The compositions of matter according to the present invention can be conveniently prepared by a variety of methods. The compositions of matter according to the present invention can be prepared utilizing an aqueous phase polymerization method wherein 1 H-thieno[3,4-d]imidazol-2(3H)-one, at least one polyanion and at least one oxidant are reacted in the presence of water under conditions sufficient to form poly(1H-thieno[3,4-d]imidazol-2(3H)-one). The temperature for conducting the polymerization is not critical but affects the rate of polymerization. Suitable temperatures range from about 5°C to about 90°C

Another embodiment of the invention relates to polythiophenes and polyselenophenes which are formed from structural units formula M1, as follows: 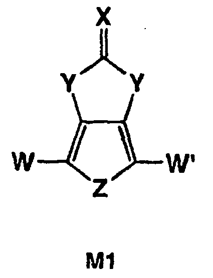 Z is Se, S, O, NR₁, or PR₁, where R₁ is hydrogen, alkylaryl, arylalkyl, or aryl; Y is independently selected from NH, O, C(R)₂, N(R)₂ and S; X is O, S, Se or NH. R is a substituted or unsubstituted C1-C4 alkyl group. W and W' are H, halogen atoms, e.g., F, Cl, Br, and I, metallorganics, e.g., MgCl, MgBr, Mgl, Sn(R₂)₃, where R₂ is C₁₋₆ alkyl or C₁₋₆ alkyl ether, boronic acid, boronic ester, vinyl units, e.g., -CH=CHR₃ where R₃ is H or C₁₋₆ alkyl, ether, i.e., -OC₁₋₆ alkyl, esters, i.e., -COOC₁₋₆ alkyl, -S-COR₄ and -COR₄ where R₄ is H or C₁₋₆ alkyl, -C≡CH, and polymerizable aromatic rings such as phenyl, naphthalene, pyrrole, and thiophene. Derivatives of the substituted claimed compositions can be formed prior to or after addition of the secondary or tertiary functionality.

Useful monomers for producing homopolymers and copolymers are those where W and W' are H and represented by the formula M3, as follows: 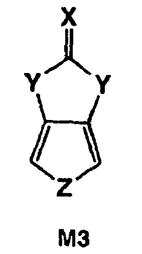 X, Y and Z are the groups described above with respect to formula M1.

Polymers, according to the present invention, include homopolymer having a repeating unit having formula P1, as follows: 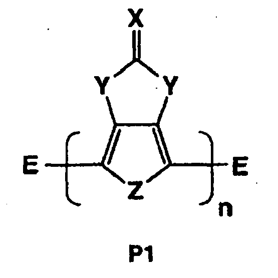 wherein n is an integer greater than 4; Z is Se, S, O, NR₁, or PR₁, where R₁ is hydrogen, alkylaryl, arylalkyl, or aryl; Y is independently selected from NH, O, C(R)₂, N(R)₂ and S; X is O, S, Se or NH and E is independently selected from functional or non-functional end-groups. R is a substituted or unsubstituted C1-C4 alkyl group. E is independently selected from functional and non-functional end-groups. The repeating structures according to the present invention may be substantially identical, forming a homopolymer, or may have Z, Y, and X independently selected for each unit, resulting in a copolymeric compound. The repeating unit may be terminated in any suitable manner known in the art and may include functional or non-functional end groups.

Electrically conducting oligomers and polymers comprised of copolymerized units of monomers M2 are another aspect of the invention and are represented by the formula P2, as follows: 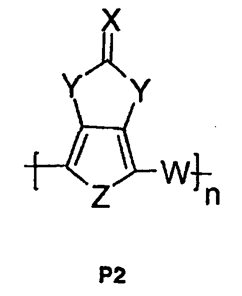 where n is an integer, W is -CZ¹=CZ²- or -C≡C-, and Z¹ and Z² are independently of each other H, F, Cl or CN. Oligomers often have n-values from about 2 to 10 units and these products lend themselves to the production of memory and field effect transistor devices. Polymers having n-values from about 11 to about 50,000 units, often from about 20 to about 10,000 units are quite useful in preparing films as hole injection materials in various electrooptical applications. The copolymer of formula P2 may terminate in any suitable manner (e.g., hydrogen, deuterium, vinyl, acetylene, or nitrile) and may include any suitable polymerization end-groups (e.g., vinyl, acetylene, phenyl, pyrrole, thiophene, fluorene, or carbazole).

Polymerization of the monomer described above may take place through one of several reaction mechanisms. Suitable reaction mechanisms include 1) aqueous phase/oxidant polymerization, 2) organic solvent phase/oxidant polymerization, 3) metal catalyst polymerization, and 4) electrochemical polymerization. In some cases, the polymerization can be conducted in situ upon a substrate. Depending upon the end use the substrate may be pretreated or coated prior to polymerization and/or the polymerized surface can be further process (e.g., additional films or layers can be applied upon the polymer).

The conductive polymers formed from a process of one embodiment of the invention possess functionalities that can enable solid state engineering through hydrogen bonding interactions. Depending of the choice of Y and X of formula M1 the structural motifs generated through hydrogen bonding interaction may vary greatly. The structural motifs may be varied by adding additives or other hydrogen bonding enabling molecules as described in the open literature. For examples see, Journal of the American Chemical Society, 1996, 118, 4018-4029 and references therein. Monomers for formation of the polymer according to the present invention, such as 1 H-thieno[3,4-d]imidazol-2(3H)-one, can form a structural motif that may be characterized as a linear tape. The linear motif can be maintained through out the polymerization leading to films of polymers that are highly ordered as evident by their very high gloss. Monomers which form conductive polymers upon polymerization but lack solid state engineering through hydrogen bonding appear flat and display high surface roughness values.

Typical reaction conditions for aqueous phase polymerization include temperatures ranging from about 0º to about 100ºC. The polymerization is continued for a period of time until the reaction is completed to affect the desired degree of polymerization. The degree of polymerization is not a critical element of this invention, but shall vary depending upon the end use application. The desired degree of polymerization shall depend upon the end use as is readily determined by one of ordinary skill in the art without undue experimentation. The polymerization time may range between a few minutes up to about 48 hours and depends on a number of factors including the size of the reactor utilized in the polymerization, the polymerization temperature and the oxidant utilized in the polymerization process.

The amount of polyanion and oxidant to be employed in the aqueous polymerization method may broadly vary and can be determined for any given polymerization without undue experimentation. For example the weight ratio of 1 H-thieno[3,4-d]imidazol-2(3H)-one monomer to a desired polyanion typically ranges from about 0.001 to about 10, typically about 0.05 to about 1.0. The weight ratio of 1 H-thieno[3,4-d]imidazol-2(3H)-one monomer to a desired oxidant typically ranges from about 0.01 to about 10 usually about 0.1 to about 2.0. In the case of ferric sulfate, the amount used ranges from about 0.1 wt% to about 5 wt% of 1H-thieno[3,4-d]imidazol-2(3H)-one.

Suitable polyanions can comprise at least one member from the group of an anion of a polycarboxylic acid, such as polyacrylic acid, polymethacrylic acid, nafion, polymaleic acid, and polymeric sulfonic acids, such as polystyrene sulfonic acid and polyvinyl sulfonic acid. The polycarboxylic and polysulfonic acids may also be copolymers of vinyl carboxylic and vinyl sulfonic acids with other monomers, such as acrylates and styrene. The molecular weight of the acids supplying the polyanions is normally in the range from about 1,000 to about 500,000, usually from about 2000 to about 500,000 and normally about 70,000. The acids from which the polyanions are derived are commercially available or may be produced by known methods.

Suitable oxidants can comprise at least one member from the group of iron(III) salts, such as FeCl₃, Fe(ClO₄)₃ and the iron (III) salts of organic acids and inorganic acids containing organic residues, H₂O₂, K₂Cr₂O₇, alkali or ammonium persulfates, alkali perborates, potassium permanganate and copper salts such as copper tetrafluoroborate. In addition iodine, air and oxygen may advantageously be used as oxidants. Persulfates and the iron(III) salts of organic acids and inorganic acids containing organic residues are useful because they are not corrosive to the substrates such as ITO, or oxides of aluminum, tantalum, or niobium.

Examples of iron(III) salts of organic acids can comprise at least one member from the group of Fe(III) salts of C₁₋₃₀ alkyl sulfonic acids, such as methane or dodecane sulfonic acid; aliphatic C₁₋₂₀ carboxylic acids, such as 2-ethylhexylcarboxylic acid, aliphatic perflurocarboxylic acids, such as trifluoroacetic acid and perfluorooctanoic acid; aliphatic dicarboxylic acids, such as oxalic acid and, aromatic, optionally C₁₋₂₀-alkylsubstituted sulfonic acids, such as benzenesulfonic acid, p-toluene-sulfonic acid and dodecyl benzenesulfonic acid and mixtures of the aforementioned Fe(III) salts of organic acids. Examples of iron(III) salts of inorganic acids containing organic residues can comprise at least one member from the group of iron(III) salts of sulfuric acid semiesters of C₁₋₂₀ alkanols, for example the Fe(III) salt of lauryl sulfate.

Polymers, including homopolymers may be formed by the following aqueous phase reaction:

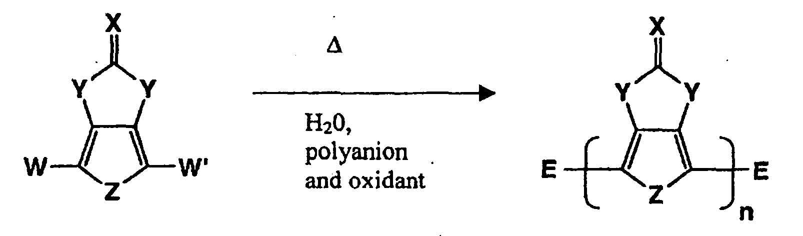

Copolymers according to the present invention may be formed by the following aqueous reaction:

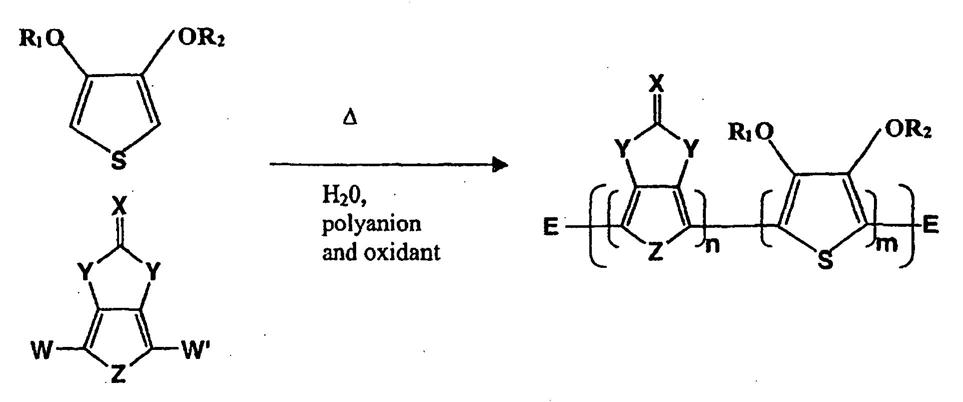

Although the above copolymerization reaction shows a substituted thiophene as the copolymerization agent, any number of compounds may be used to polymerize in the reaction according to the present invention.

The oxidative polymerization of the monomers described above in the aqueous solvent phase is generally carried out at temperatures of from about 20° to about 250°C, usually at temperatures of from about 20° and about 200°C, depending on the oxidant used and the reaction time desired. Polymers, including homopolymers may be formed by the following organic phase reaction:

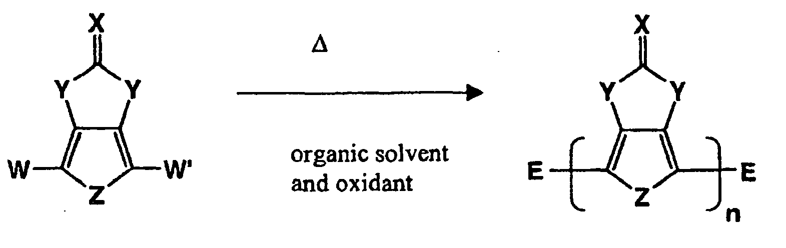

Similar to reactions conducted in the aqueous phase, copolymers may also be formed by providing additional monomer structures. Solvents suitable for use with the monomers of the formula M1 and/or oxidants are, in particular, the following organic solvents which are generally inert under the reaction conditions and can comprise at least one member from the group of: aliphatic alcohols such as methanol, ethanol and i-propanol; aliphatic ketones such as acetone and methyl ethyl ketone; aliphatic carboxylic esters such as ethyl acetate and butyl acetate; aromatic hydrocarbons such as toluene and xylene; aliphatic hydrocarbons such as hexane, heptane and cyclohexane; chlorinated hydrocarbons such as dichloromethane and dichloroethane; aliphatic nitriles such as acetonitrile; aliphatic sulphoxides and sulphones such as dimethyl sulphoxide and sulpholane; aliphatic carboxamides such as methyl acetamide and dimethylformamide; aliphatic and araliphatic ethers such as diethyl ether and anisole. In addition, water or mixtures of water with the abovementioned organic solvents can also be used as solvents.

Oxidants suitable for use with the present invention include oxidants that are suitable for oxidative polymerization of pyrrole. These oxidants are described, for example, in J. Am.Chem. Soc. 85, 484 (1963); hereby incorporated by reference. Inexpensive oxidants can comprise oxidants such as iron(III) salts such as FeCl₃, Fe(Cl0₄)₃ and the iron(III) salts of organic acids and inorganic acids containing organic radicals, furthermore H₂O₂, K₂Cr₂O₇, alkali metal persulphates, ammonium persulphates, alkali metal perborates, potassium permanganate and copper salts, such as copper tetrafluoroborate, are useful.

For the oxidative polymerization of the monomer of the formula M1, about 2 to about 2,5 equivalents of oxidant are theoretically required per mol of monomer (see e.g. J. Polym. Sc. Part A Polymer Chemistry Vol. 26, S, 1287 (1988); hereby incorporated by reference). In practice, however, the oxidant is applied in a certain excess, e.g. in an excess of about 0.1 to about 2 equivalents per mol of monomer.

The use of persulphates and iron(III) salts of organic acids and of inorganic acids containing organic radicals has the great application advantages that they do not have a corrosive action (e.g., with respect to ITO, or oxides of aluminum, tantalum, or niobium) and, in particular, that the oxidation of the monomers of the formula M1 proceeds so relatively slowly when they are used, monomers and oxidants can be applied together onto a metal foil or a metal oxide surface in the form of a solution or from a printing paste. In this embodiment, after application of the solution or the paste, the oxidation can be accelerated by warming the coated metal foil or the coated metal oxide surface (e.g., warmed to a temperature of about 200C).

When the other abovementioned oxidants such as FeCl₃, H₂O₂ or perborates are used, the oxidative polymerization proceeds relatively quick such that separate application of oxidants and monomer onto the substrate to be coated is desirable, but, in contrast, warming can be omitted.

Examples which may be mentioned of iron(III) salts of inorganic acids containing organic radicals can comprise at least one member from the group of iron(III) salts of the monoesters of sulphuric acid with C₁ -C₂₀ -alkanols, for example the Fe(III) salt of lauryl sulphate.

Examples which may be mentioned of iron(III) salts of organic acids can comprise at least one member from the group of Fe(III) salts of C₁-C₂₀ -alkylsulphonic acids, such as of methane- and dodecane-sulphonic acid; of aliphatic C₁-C₂₀ -carboxylic acids, such as of 2-ethylhexylcarboxylic acid; of aliphatic perfluorocarboxylic acids, such as of trifluoroacetic acid and of perfluorooctanoic acid; of aliphatic dicarboxylic acids, such as of oxalic acid and, in particular, of aromatic sulphonic acids which are optionally substituted by C₁ -C₂₀ -alkyl groups, such as benzenesulphonic acid, p-toluenesulphonic acid and of dodecylbenzenesulphonic acid. Mixtures of these above-mentioned Fe(III) salts of organic acids can also be employed.

When the monomers of the formula M1 and the oxidants are applied separately, metal foil substrates can be initially coated with the solution of the oxidant and subsequently with the solution of the monomer. When, as desired, the monomer and oxidant are applied together onto metal foil, the metal foils are typically coated with one solution, namely a solution containing a monomer and an oxidant. Since a portion of the monomer evaporates during this joint application the oxidant can be added to the solution in an amount that is reduced in accordance with the anticipated loss of monomer.

In addition, the above solutions may contain organic binders which are soluble in organic solvents, such as at least one member from the group of poly(vinyl acetate), polycarbonate, poly(vinyl butyrate), polyacrylates, polymethacrylates, polystyrene, polyacrylonitrile, poly(vinyl chloride), polybutadiene, polyisoprene, polyethers, polyesters, silicones, and pyrrole/acrylate, vinyl acetate/acrylate and ethylene/vinyl acetate copolymers each of which are soluble in organic solvents. Water-soluble binders such as polyvinyl alcohols can be employed as thickeners.

The solutions to be applied to the metal foil which can contain about 1 to about 30% by weight of the monomer derivative of the formula M1 and about 0 to about 30% by weight of binder, both percentages by weight being based on the total weight of the solution. The solutions are applied to the substrates by known processes, for example by spraying, knife coating, spreading or printing. The thickness of the applied coating after drying is generally about 1.0 to about 500 µm, usually about 10 to about 200 µm, depending on the desired conductivity of the coating.

After application of the solutions, the solvents can be removed by evaporation at room temperature. In order to achieve higher processing rates, it is, however, more advantageous to remove the solvents at elevated temperatures, for example at temperatures of from about 20° to about 300°C, usually about 40° to about 250°C. The removal of the solvents at elevated temperature is also more advantageous since it has been found that the electrical conductivity of the coating can be increased substantially, namely by up to a power of ten, by thermal after treatment of the coatings at temperatures of from about 50° to about 250°C., normally about 100° to about 200°C. The thermal after treatment can be combined directly with the removal of the solvent or alternatively carried out at an interval in time from finishing the coating. Depending on the type of polymer used for the coating, the thermal treatment can take about 5 seconds to about 5 minutes.

The thermal treatment can be carried out, for example, by moving the coated metal foils through a heating chamber at the desired temperature at a rate such that the residence time desired at the selected temperature is achieved, or bringing the coated metal foils into contact with a hotplate at the desired temperature for the desired residence time. After removal of the solvents (drying) and before thermal after treatment, it may be advantageous to wash the excess oxidant out of the coating using water.

The nature of the polymerization and the desired polymer can be controlled depending upon what W and W' groups are present. Carbon-carbon bond forming reactions may be completed following any suitable methods. Methods suitable for use with the monomer of the present invention include, but are not limited to the Suzuki Reaction, the Yamamoto Reaction, the Heck Reaction, the Stille Reaction, the Sonogashira-Hagihara Reaction, the Kumada-Corriu Reaction, the Riecke Reaction, and the McCullogh Reaction.

Monomers of the Formula M1 can lend themselves to metal-catalyzed polymerizations. For examples see, Heck, Chem, Rev. 2000, 100,3009-3066*;* Stille, Chem. Rev. 2003, 103,169-196*;* Suzuki, Chem. Rev. 1995, 95, 2457-2483 ; Sonogashira - Hagihara, Chem, Rev. 2003, 103, 1979-2017; and Kumada-Corriu, Chem. Rev. 2002, 102, 1359-1469 incorporated herein by reference. Conditions can vary greatly depending on the nature the W and W' substituents.

An alternate method for preparing oligomers and polymers, such as poly(1H-thieno[3,4-d]imidazol-2(3H)-one), involves an electrochemical process wherein 1 H-thieno[3,4-d]imidazol-2(3H)-one is polymerized in an electrochemical cell using a three electrode configuration. A suitable three electrode configuration comprises a button working electrode selected from the group consisting of platinum, gold and vitreous carbon button working electrodes, a platinum flag counter electrode and an Ag/Ag+ nonaqueous reference electrode. Suitable electrolytes can comprise at least one member selected from the group consisting of tetrabutylammonium perchlorate/acetonitrile, lithium triflate/acetonitrile and tetrabutylammonium hexafluorophosphate/acetonitrile.

Polymers, including homopolymers may be formed by the following electrochemical reaction:

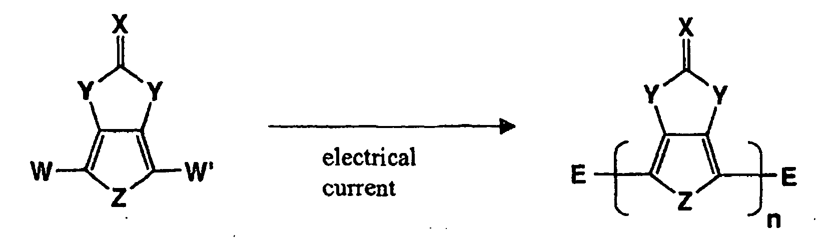

1H-thieno[3,4-d]imidazol-2(3H)-one may undergo electrochemical oxidation at a peak above 1.1 V to provide the polymer, poly(1 H-thieno[3,4-d]imidazol-2(3H)-one) on the surface of the working electrode. Upon completion of the polymerization, the polymer is removed from the working electrode by washing with a solvent such as acetonitrile.

Conventional electrolytic cells can be utilized to practice the electrochemical process for making the compositions of matter of the present invention. One suitable working electrode for making the compositions of matter of this invention is a vitreous carbon electrode and the electrolyte can comprise tetrabutylammonium perchlorate/acetonitrile.

1 H-thieno[3,4-d]imidazol-2(3H)-one was also electrochemically polymerized in the presence of sodium poly(styrene sulfonate) using cyclovoltammetric polymerization. An onset for oxidation was observed at about 1.12 V which corresponds to the potential at which polymerization can ensue. Polymerization is evident as indicated by the increase in current response for the lower redox process which corresponds to the reduction and oxidation of the conducting polymer that had been electroprecipitated onto the electrode surface.

In one embodiment of the invention, the oxidative polymerization of 1 H-thieno[3,4-d]imidazol-2(3H)-one is carried out in aqueous solution utilizing poly(styrene sulfonic acid) as the polyanion and ammoniumpersulfate and/or iron(III) sulfate as the chemical oxidant.

The above described polymerization has been in terms of a homopolymerization but the inventive process can be used to conduct a copolymerization of the 1H-thieno[3,4-d]imidazol-2(3H)-one with another monomer such as 3,4-ethylenedioxythiophene or pyrrole, among other reactions.

### EXAMPLES

The following illustrative examples are provided to further describe how to make and use the compositions of matter and are not intended to limit the scope of the claimed invention. Unless otherwise states, parts and percentages in the examples are given by weight.

### Example 1

### Aqueous Synthesis of Poly(1 H-thieno[3,4-d]imidazol-2(3H)-one)

50 mg (0.36 mmol) of 1H-thileno[3,4-d]imidazol-2(3H)-one and 830 mg of 18% poly(styrenesulfonic acid) water solution in 10 ml of deionized water was added to a 25 ml 1-neck flask. The mixture was stirred at 600 rpm. 113.0 mg (0.48 mmol) of (NH₄)₂S₂O₈ and 2 mg of Fe₂(SO₄)₃ were added to the reaction flask. The oxidative polymerization was carried out in excess of one hour. After polymerization, the aqueous solution was purified by ion exchange columns (Amberlite IR-120 and MP62) resulting in a deep black aqueous poly(1 H-thieno[3,4-d]imidazol-2(3H)-one)/poly(styrene sulfonic acid) dispersion. Transparent films were prepared by spin coating the poly(1H-thieno[3,4-d]imidazol-2(3H)-one)/poly(styrene sulfonic acid) mixture onto glass substrates at 1,000 rpm yielding an electrically conductive surface.

### Example 2

### Aqueous Synthesis of Poly(1H-thieno[3,4-d]imidazol-2(3H)-one)

50 mg (0.36 mmol) of 1 H-thieno[3,4-d]imidazol-2(3H)-one and 5.55 g of 18% poly(styrenesulfonic acid) water solution in 45 ml of deionized water was added to a 100 ml 1-neck flask. The mixture was stirred at 1200 rpm. 300 mg (1.98 mmol) of Fe₂(SO₄)₃ dissolved in 7 mL deionized water were added to the reaction flask. The oxidative polymerization was carried out in excess of one hour. After polymerization, the aqueous solution was purified by ion exchange columns, resulting in a deep black aqueous Poly(1H-thieno[3,4-d]imidazol-2(3H)-one)/poly(styrene sulfonic acid) dispersion. Transparent films were prepared by spin coating the poly(1 H-thieno[3,4-d]imidazol-2(3H)-one)/poly(styrene sulfonic acid) mixture onto glass substrates at 1,000 rpm yielding an electrically conductive surface. The optical bandgap of the polymer was measured as 1.5 eV.

### Example 3

### Aqueous Synthesis of Poly(1H-thieno[3,4-d]imidazol-2(3H)-one)

50 mg (0.36 mmol) of 1H-thieno[3,4-d]imidazol-2(3H)-one and 8.4 g of 12% NAFION^{®} perfluorinated ion-exchange resin water dispersion in 42 ml of deionized water was added to a 100 ml 1-neck flask. NAFION^{®} is a federally registered trademark of E.I. DuPont deNemours and Company, Wilmington, DE. The mixture was stirred at 1200 rpm. 300 mg (1.98 mmol) of Fe₂(SO₄)₃ dissolved in 7 mL deionized water were added to the reaction flask. The oxidative polymerization was carried out in excess of one hour. After polymerization, the aqueous solution was purified by ion exchange columns, resulting in a deep black aqueous poly(1H-thieno[3,4-d]imidazol-2(3H)-one)/Nafion dispersion. Transparent films were prepared by spin coating the poly(1 H-thieno[3,4-d]imidazol-2(3H)-one)/Nation mixture onto glass substrates at 1,000 rpm yielding an electrically conductive surface. The optical band gap of the polymer was measured as 1.5 eV.

Several dispersions featuring a wide range of monomer to polysulfonic acid (NAFION®) ratios (based on weight) were made displaying a range in desirable properties such as work function, particle size, and film smoothness. The following table illustrates the properties of such dispersions..

| PTI/polysulfonic acid | Work Function | RMS of Film | Dispersion Particle Size |
|---|---|---|---|
| 1/10 | 5.30 eV | 4.1 nm | 101 nm |
| 1/20 | 5.52 eV | 2.9 nm | 82 nm |
| 1/30 | 5.64 eV | 1.9 nm | 23 nm |
| 1/50 | 5.92 eV | 1.1 nm | 26 nm |

### Example 4

### Aqueous Synthesis of Poly(1H-thieno[3,4-d]imidazol-2(3H)-one)

50 mg (0.36 mmol) of 1 H-thieno[3,4-d]imidazol-2(3H)-one and 8.4 g of 12% NAFION® perfluorinated ion-exchange resin water dispersion in 42 ml of deionized water was added to a 100 ml 1-neck flask. The mixture was stirred at 1200 rpm. 113.0 mg (0.48 mmol) of (NH₄)₂S₂O₈ and 2 mg of Fe₂(SO₄)₃ were added to the reaction flask. The oxidative polymerization was carried out in excess of one hour. After polymerization, the aqueous solution was purified by ion exchange columns (Amberlite IR-120 and MP62) resulting in a deep black aqueous poly(1H-thieno[3,4-d]imidazol-2(3H)-one)/ NAFION^{®} dispersion. Transparent films were prepared by spin coating the poly(1H-thieno[3,4-d]imidazol-2(3H)-one)/poly(styrene sulfonic acid) mixture onto glass substrates at 1,000 rpm yielding an electrically conductive surface. The optical bandgap of the polymer was measured as 1.5 eV.

### Example 5

### Solvent (in-situ) Synthesis of Poly(1 H-thieno[3,4-d]imidazol-2(3H)-one)

280 mg (2 mmol) of 1 H-thieno[3,4-d]imidazol-2(3H)-one were dissolved in 15 mL anhydrous n-butanol. 2.25 g (3.3 mmol) of iron (III) p-toluenesulfonate hexahydrate dissolved in 5 mL of anhydrous n-butanol was added to the monomer solution resulting in a deep red solution. The mixture was drop cast on glass substrates and allowed to dry. The dried film was cured at temperatures up to 120°C for up to 15 minutes. The resulting film was conductive as determined by the four-point-probe measurement. The formed polymer film appeared grey to the naked eye absorbing weakly and uniformly across the visible spectrum. The vis-NIR spectrum displayed a bipolaron band around 1700 nm.

### Example 6

### Electrochemical Synthesis and Characterization of Poly(1H-thieno[3,4-d]imidazol-2(3H)-one)

1H-thieno[3,4-d]imidazol-2(3H)-one was dissolved in tetrabutylammonium hexafluorophosphate/acetonitrile solution to a concentration of 5mM monomer and 100 mM electrolyte and was electrochemically polymerized employing a 3-electrode configuration, using a platinum button working electrode (2 mm diameter), platinum flag counter electrode (1 cm²), and a Ag/Ag+ nonaqueous reference electrode (4.82 V versus vacuum level as determined by calibration with a ferrocene solution). The monomer exhibits a low oxidation potential with an onset at 5.66 eV. Polymerization was apparent from the current response increase in regular intervals at a lower redox potential upon repetitive scans.

The polymers electronic properties were evaluated in an acetonitrile solution being 100 mM in tetrabutylammonium hexafluorophosphate. Scan rate dependency was carried out at scan rates of 25, 50, 100, 200 and 400 mV/s. The peak current for the reductive process of the polymer was found to scale linearly with the scan rate indicating that poly(1 H-thieno[3,4-d]imidazol-2(3H)-one) was adhered to the surface of the electrode. The formed polymer was evaluated by cyclic voltammetry and displayed an HOMO of -4.7 eV. The electrochemically band gap was found to be 1.65 eV. Differential Pulse Voltammetry gave rise to a HOMO of -4.67 eV.

### Example 7

### Copolymerization of 1 H-thieno[3,4-d]imidazol-2(3H)-one and 3,4-ethylenedioxythiophene.

A copolymer of 1 H-thieno[3,4-d]imidazol-2(3H)-one and 3,4-ethylenedioxthiophene was prepared according to the procedure set forth in Example 6 except that a solution was prepared consisting of 5 mM 1 H-thieno[3,4-d]imidazol-2(3H)-one and 5 mM ethylenedioxythiophene in 0.1 M tetrabutylammonium hexafluorophosphate (TBAPF₆)/ACN. Polymerization was evidenced by the increase in current of the lower redox process upon sequential scanning and the onset of oxidation of the formed copolymer as measured by Differential Pulse Voltammetry. The copolymer displayed an onset of -0.36 V against ferrocene. (Electrochemically synthesized poly(1H-thieno[3,4-d]imidazol-2(3H)-one) has an onset of -0.15 V and poly(3,4-ethylenedioxthiophene) has an onset of -0.71 V.)

While the invention has been described with reference to certain embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A process for forming an electrically conductive polymer comprising:
providing a mixture comprising:
a monomer component having the following structure: 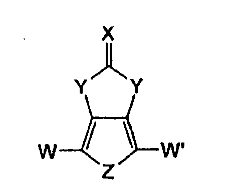 wherein Z comprises at least one member selected from the group consisting of Se, S, O, NR₁, or PR₁, where R₁ comprises hydrogen, alkylaryl, arylalkyl, or aryl; Y comprises a member independently selected from the group consisting of NH, O, C(R)₂, N(R)₂ and S; X comprises a member independently selected from the group consisting of O, S, Se or NH; W and W' are independently selected from the group consisting of H, halogen atoms, metallorganics, boronic acid, boronic ester, vinyl units, -S-COR₄ and -COR₄; R comprises a member independently selected from the group consisting of substituted or unsubstituted C1-C4 alkyl groups; and R₄ comprises a member independently selected from the group consisting of H or C₁₋₆ alkyl, -C≡CH, and polymerizable aromatic rings;
water;
a polyanion; and
an oxidant;
reacting the mixture for a sufficient time and at a sufficient temperature to produce a polymer having electrically conductive properties.

2. The process of claim 1, wherein the mixture is maintained at a temperature from about 0°C to about 100°C.

3. The process of claim 1 or 2, wherein the polyanion comprises at least one anion selected from the group consisting of an anion of a polyacrylic acid, polymethacrylic acid, polysulfonic acid, polymaleic acid, polystyrene sulfonic acid, polyvinyl sulfonic acid, copolymers of vinyl carboxylic acid with acrylate or styrene, vinyl sulfonic acids with acrylate or styrene, and combinations thereof.

4. The process of any one of claims 1 to 3, wherein the polyanion comprises a molecular weight of about 1,000 to about 500,000.

5. A process for forming an electrically conductive polymer comprising:
providing a mixture comprising:
a monomer component having the following structure: 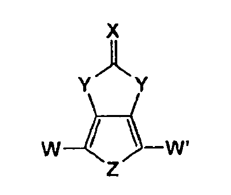 wherein Z is Se, S, O, NR₁, or PR₁, where R₁ is hydrogen, alkylaryl, arylalkyl, or aryl; Y is independently selected from the group consisting of NH, O, C(R)₂, N(R)₂ and S; X is independently selected from the group consisting of O, S, Se or NH; W and W' are independently selected from the group consisting of H, halogen atoms, metallorganics, boronic acid, boronic ester, vinyl units, -S-COR₄ and -COR₄; R is independently selected from the group consisting of substituted or unsubstituted C1-C4 alkyl groups; and R₄ is independently selected from the group consisting of H or C₁₋₆ alkyl, -C≡CH, and polymerizable aromatic rings;
solvent; and
an oxidant;
reacting the mixture for a sufficient time and at a sufficient temperature to produce a polymer having electrically conductive properties.

6. The process of claim 5, wherein the mixture is maintained at a temperature from about 20°C to about 250°C.

7. The process of any one of claims 5 or 6, wherein the solvent is selected from the group consisting of aliphatic alcohols, aliphatic ketones, aliphatic carboxylic esters, aromatic hydrocarbons, aliphatic hydrocarbons, chlorinated hydrocarbons, aliphatic nitriles, aliphatic sulphoxides and sulphones, aliphatic carboxamides, aliphatic and araliphatic ethers, aqueous solutions thereof and combinations thereof.

8. The process of any one of claims 1 to 7, wherein the mixture is reacted for about 5 minutes to about 48 hours.

9. The process of any one of claims 1 to 8, wherein the oxidant comprises at least one compound selected from the group consisting of iron(III) salts, H₂O₂, K₂Cr₂O₇, alkali persulfate, ammonium persulfate, alkali perborate, potassium permanganate, copper salts, iodine, air and oxygen.

10. A process for forming an electrically conductive polymer comprising:
providing a mixture comprising:
a monomer component having the following structure: 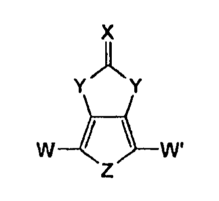 wherein Z is Se, S, O, NR₁, or PR₁, where R₁ is hydrogen, alkylaryl, arylalkyl, or aryl; Y is independently selected from the group consisting of NH, O, C(R)₂, N(R)₂ and S; X is independently selected from the group consisting of O, S, Se or NH; W and W' are independently selected from the group consisting of H, halogen atoms, metallorganics, boronic acid, boronic ester, vinyl units, -S-COR₄ and -COR₄; R is independently selected from the group consisting of substituted or unsubstituted C1-C4 alkyl groups; and R₄ is independently selected from the group consisting of H or C₁₋₆ alkyl, -C≡CH, and polymerizable aromatic rings;
an electrolyte
placing the mixture in contact with an electrolytic cell;
providing a current through the mixture to polymerize the monomer.

11. The process of any one of claims 1 to 10, further comprising applying the mixture to a substrate,
wherein the substrate preferably comprises at least one material selected from the group consisting of glass, organic polymers, plastic, silicon, minerals, semiconducting materials, ceramics, metals and combinations thereof.

12. The process of any one of claims 1 to 11, further reacting the mixture with a dopant comprising at least one compound selected from the group consisting of HCl, HNO₃, H₂SO₄, H₃PO₄, HBr, HI, dodecyl benzene sulfonic acid, lauryl sulfonic acid, camphor sulfonic acid, organic acid dyes, methane sulfonic acid, toluene sulfonic acid, poly(styrene sulfonic acid), copolymers of sulphonic acid, acetic acid, propionic acid, butyric acid, hexanoic acid, adipic acid, azelaic acid, oxalic acid, poly(acrylic acid), poly(maleic acid), poly(methacrylic acid) and copolymers of carboxylic acid and combinations thereof.

13. The process of any one of claims 1 to 12, further reacting the mixture with a dopant comprising at least one compound selected from the group consisting of Na, K, Li, Ca, I₂, (PF₆)⁻, (SbF₆)⁻, and FeCl₃.

14. A composition of matter comprising:
a polymer having the following structure: 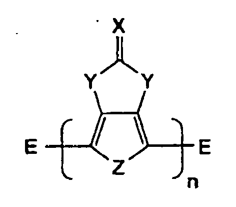
wherein n is an integer greater than 4; Z comprises at least one member selected from the group consisting of Se, S, O, NR₁, or PR₁, where R₁ is hydrogen, alkylaryl, arylalkyl, or aryl; Y comprises at least one member independently selected from the group consisting of NH, O, C(R)₂, N(R)₂ and S; X is independently selected from the group consisting of O, S, Se or NH; E comprises at least one member independently selected from functional or non-functional end-groups; and R comprises at least one member independently selected from the group consisting of substituted or unsubstituted C1-C4 alkyl groups.

15. The composition of claim 14, wherein the composition comprises an aqueous dispersion.

16. The composition of claim 15 further comprising a substrate.

17. The composition of claim 16, wherein the substrate comprises at least one material selected from the group consisting of glass, organic polymers, plastic, silicon, minerals, semiconducting materials, ceramics, metals and combinations thereof.

18. The composition of claim 17, wherein the substrate and polymer form at least one device selected from the group consisting of an antistatic coated substrate, an electrically conductive coated substrate, an electrochromic device, a photovoltaic device, a light emitting diode, a flat panel display, a photoimageable circuit, a printable circuit, a thin film transistor device, a battery, an electrical switch, a coated capacitor, a corrosion resistant coated substrate, an electromagnetic shielding material, a sensor and other optoelectronic devices.

19. The composition of claim 18, wherein the polymer formed comprises electrical properties.

20. The composition of claim 19, wherein the electrical properties comprise at least one property selected from the group consisting of electrical conductivity, semiconductivity, electroluminescence, electrochromicity, photovoltaic properties and combinations thereof.

21. The composition of claim 14, wherein the polymer further comprises repeating structural units having the following structure: 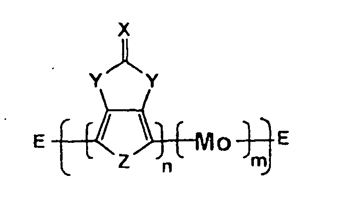 wherein n and m are independently selected integers having a total n+m of greater than 4 and Z comprises at least one member selected from the group consisting of Se, S, O, NR₁, or PR₁, where R₁ comprises hydrogen, alkylaryl, arylalkyl, or aryl; Y comprises at least one member independently selected from NH, O, C(R)₂, N(R)₂ and S; X comprises at least one member selected from the group consisting of O, S, Se or NH and E comprises at least one member independently selected from functional or non-functional end-groups, R comprises at least one substituted or unsubstituted C1-C4 alkyl group and wherein the n-unit substructure and m-unit substructure of the copolymer comprise at least one member selected from the group consisting of random copolymers, graft copolymers, block copolymers, and dendritic structures and Mo in the structure comprises at least one electroactive or non-electroactive monomer copolymerizable with the n-unit substructure comprising at least one member selected from the group consisting of thieno[3,4-b]thiophenes and substituted thiophenes.

22. The composition of claim 14, wherein the polymer comprises at least one homopolymer.

23. The composition of claim 14, wherein the polymer comprises at least one block copolymer.

24. A polymer having polymerized units of the following structure: 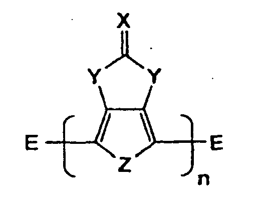 wherein n is an integer greater than 4; Z comprises at least one member selected from the group consisting of Se, S, O, NR₁, or PR₁, where R₁ is hydrogen, alkylaryl, arylalkyl, or aryl; Y comprises at least one member independently selected from the group consisting of NH, O, C(R)₂, N(R)₂ and S; X is independently selected from the group consisting of 0, S, Se or NH; E comprises at least one member independently selected from functional or non-functional end-groups; and R comprises at least one member independently selected from the group consisting of substituted or unsubstituted C1-C4 alkyl groups.

25. The composition of claim 14, wherein the aqueous dispersion further comprises at least one additive selected from the group consisting of particulate copper, silver, nickel, aluminum, carbon black, talc, mica, wollastonite, silica, clay, TiO₂, dyes, pigments, and combinations thereof.

26. A method for forming a polymeric coating comprising:
providing an aqueous dispersion comprising
a polymer having the following structure: 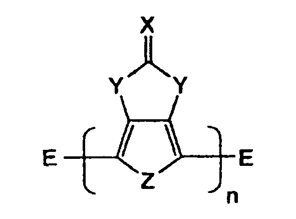 wherein n is 4 or more; wherein Z is Se, S, O, NR₁, or PR₁, where R₁ is hydrogen, alkylaryl, arylalkyl, or aryl; Y is independently selected from the group consisting of NH, O, C(R)₂, N(R)₂ and S; X is independently selected from the group consisting of O, S, Se or NH; E is independently selected from functional or non-functional end-groups; and R is independently selected from the group consisting of substituted or unsubstituted C1-C4 alkyl groups;
applying the aqueous dispersion to a substrate; and
drying the aqueous dispersion to form an electrically conductive polymer coating.

27. The method of claim 26, wherein applying comprises one of the following application techniques selected from the group consisting of ink jet printing, screen printing, roll to roll printing, spin coating, meniscus and dip coating, spray coating, brush coating, blade application, curtain casting and combinations thereof.

28. The method of claim 26, wherein drying comprises evaporation at room temperature.

29. The method of claim 26, wherein drying comprises heating the aqueous dispersion.

30. An electrolyte capacitor comprising:
a first layer comprising at least one oxidizable metal;
a second layer comprising at least one oxide of the metal which covers at least a portion of a surface of the first layer; and
a third layer comprising at least one polymer which covers at least a portion of a surface of the second layer having the following formula: 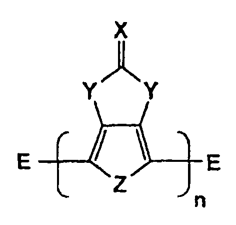
wherein n is 4 or more; wherein Z comprises at least one member selected from the group consisting of Se, S, O, NR₁, or PR₁, where R₁ is hydrogen, alkylaryl, arylalkyl, or aryl; Y comprises at least one member independently selected from the group consisting of NH, O, C(R)₂, N(R)₂ and S; X comprises at least one member independently selected from the group consisting of O, S, Se or NH; E comprises at least one member independently selected from functional or non-functional end-groups; and R comprises at least one member independently selected from the group consisting of substituted or unsubstituted C1-C4 alkyl groups.

31. The capacitor of claim 30, wherein the metal comprises at least one member selected from the group consisting of aluminum, niobium and tantalum.

32. The capacitor of claim 30 further comprising a fourth layer which covers at least a portion of a surface of the third layer comprising a conductive material.

33. The capacitor of claim 32, wherein the conductive material comprises at least one member selected from the group consisting of silver, copper or carbon black.

## Patentansprüche

1. Verfahren zur Erzeugung eines elektrisch leitfähigen Polymers, umfassend:
Bereitstellen einer Mischung, umfassend:
Eine Monomer-Komponente, die die folgende Struktur aufweist: 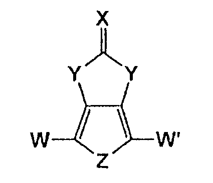 worin Z mindestens ein Mitglied umfasst, das ausgewählt ist aus der Gruppe bestehend aus Se, S, O, NR₁, oder PR₁, worin R₁ Wasserstoff, Alkylaryl, Arylalkyl, oder Aryl umfasst; Y umfasst ein Mitglied, das unabhängig ausgewählt ist aus der Gruppe bestehend aus NH, O, C(R)₂, N(R)₂ und S; X umfasst ein Mitglied, das unabhängig ausgewählt ist aus der Gruppe bestehend aus O, S, Se oder NH; W und W' sind unabhängig ausgewählt aus der Gruppe bestehend aus H, Halogenatomen, metallorganischen Verbindungen, Borsäure, Borsäureester, Vinyl-Einheiten, -S-COR₄ und -COR₄; R umfasst ein Mitglied, das unabhängig ausgewählt ist aus der Gruppe bestehend aus substituierten oder unsubstituierten C₁-C₄-Alkylgruppen; und R₄ umfasst ein Mitglied, das unabhängig ausgewählt ist aus der Gruppe bestehend aus H oder C₁₋₆-Alkyl, -C≡CH, und polymerisierbaren aromatischen Ringen;
Wasser;
Ein Polyanion; und
Ein Oxidationsmittel;
Reagieren lassen der Mischung für eine ausreichende Zeit und bei einer ausreichenden Temperatur um ein Polymer herzustellen, das elektrisch leitfähige Eigenschaften aufweist.

2. Das Verfahren nach Anspruch 1, worin die Mischung bei einer Temperatur von ungefähr 0°C bis ungefähr 100°C gehalten wird.

3. Das Verfahren nach Anspruch 1 oder 2, worin das Polyanion mindestens ein Anion, ausgewählt aus der Gruppe bestehend aus einem Anion einer Polyacrylsäure, Polymethacrylsäure, Polysulfonsäure, Polymaleinsäure, Polystyrolsulfonsäure, Polyvinylsulfonsäure, Copolymere von Vinylcarbonsäure mit Acrylat oder Styrol, Vinylsulfonsäuren mit Acrylat oder Styrol, und Kombinationen davon, umfasst.

4. Das Verfahren nach einem der Ansprüche 1 bis 3, worin das Polyanion ein Molekulargewicht von ungefähr 1.000 bis ungefähr 500.000 umfasst.

5. Verfahren zur Erzeugung eines elektrisch leitfähigen Polymers, umfassend:
Bereitstellen einer Mischung, umfassend:
Eine Monomer-Komponente, die die folgende Struktur aufweist: 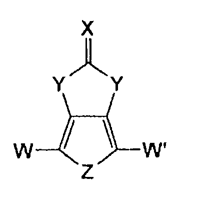 worin Z Se, S, O, NR₁, oder PR₁ ist, worin R₁ Wasserstoff, Alkylaryl, Arylalkyl, oder Aryl ist; Y ist unabhängig ausgewählt aus der Gruppe bestehend aus NH, O, C(R)₂, N(R)₂ und S; X ist unabhängig ausgewählt aus der Gruppe bestehend aus O, S, Se oder NH; W und W' sind unabhängig ausgewählt aus der Gruppe bestehend aus H, Halogenatomen, metallorganischen Verbindungen, Borsäure, Borsäureester, Vinyl-Einheiten, -S-COR₄ und -COR₄; R ist unabhängig ausgewählt aus der Gruppe bestehend aus substituierten oder unsubstituierten C₁-C₄-Alkylgruppen; und R₄ ist unabhängig ausgewählt aus der Gruppe bestehend aus H oder C₁₋₆-Alkyl, - C≡CH, und polymerisierbaren aromatischen Ringen;
Lösungsmittel; und
Ein Oxidationsmittel;
Reagieren lassen der Mischung für eine ausreichende Zeit und bei einer ausreichenden Temperatur um ein Polymer herzustellen, das elektrisch leitfähige Eigenschaften aufweist.

6. Das Verfahren nach Anspruch 5, worin die Mischung bei einer Temperatur von ungefähr 20°C bis ungefähr 250°C gehalten wird.

7. Das Verfahren nach einem der Ansprüche 5 oder 6, worin das Lösungsmittel ausgewählt ist aus der Gruppe bestehend aus aliphatischen Alkoholen, aliphatischen Ketonen, aliphatischen Carbonsäureestern, aromatischen Kohlenwasserstoffen, aliphatischen Kohlenwasserstoffen, chlorierten Kohlenwasserstoffen aliphatischen Nitrilen, aliphatischen Sulfoxiden und Sulfonen, aliphatischen Carbonsäureamiden, aliphatischen und araliphatischen Ether, wässrigen Lösungen daraus und Kombinationen daraus.

8. Das Verfahren nach einem der Ansprüche 1 bis 7, worin man die Mischung für ungefähr 5 Minuten bis ungefähr 48 Stunden reagieren lässt.

9. Das Verfahren nach einem der Ansprüche 1 bis 8, worin das Oxidationsmittel mindestens eine Verbindung umfasst, die ausgewählt ist aus der Gruppe bestehend aus Eisen(III)salzen, H₂O₂, K₂Cr₂O₇, Alkali-Persulfaten, Ammonium-Persulfaten, Alkali-Perboraten, Kaliumpermanganat, Kupfersalzen, lod, Luft und Sauerstoff.

10. Verfahren zur Erzeugung eines elektrisch leitfähigen Polymers, umfassend:
Bereitstellen einer Mischung, umfassend:
Eine Monomer-Komponente, die die folgende Struktur aufweist: 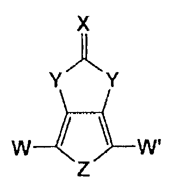 worin Z Se, S, O, NR₁, oder PR₁ ist, worin R₁ Wasserstoff, Alkylaryl, Arylalkyl, oder Aryl ist; Y ist unabhängig ausgewählt aus der Gruppe bestehend aus NH, O, C(R)₂, N(R)₂ und S; X ist unabhängig ausgewählt aus der Gruppe bestehend aus O, S, Se oder NH; W und W' sind unabhängig ausgewählt aus der Gruppe bestehend aus H, Halogenatomen, metallorganischen Verbindungen, Borsäure, Borsäureester, Vinyl-Einheiten, -S-COR₄ und -COR₄; R ist unabhängig ausgewählt aus der Gruppe bestehend aus substituierten oder unsubstituierten C₁-C₄-Alkylgruppen; und R₄ ist unabhängig ausgewählt aus der Gruppe bestehend aus H oder C₁₋₆-Alkyl, - C=CH, und polymerisierbaren aromatischen Ringen;
Einen Elektrolyt;
In-Kontakt-Bringen der Mischung mit einer elektrolytischen Zelle;
Bereitstellen von Strom durch die Mischung, um das Monomer zu polymerisieren.

11. Das Verfahren nach einem der Ansprüche 1 bis 10, weiterhin umfassend das Aufbringen der Mischung auf ein Substrat.

12. Das Verfahren nach einem der Ansprüche 1 bis 11, weiterhin Reagieren lassen der Mischung mit einem Dotierstoff umfassend mindestens eine Verbindung, die ausgewählt ist aus der Gruppe bestehend aus HCl, HNO₃, H₂SO₄, H₃PO₄, HBr HI, Dodecylbenzolsulfonsäure, Laurylsulfonsäure, Campfersulfonsäure, organische Säurefarbstoffe, Methansulfonsäure, Toluolsulfonsäure, Poly(styrolsulfonsäure), Copolymere der Sulfonsäure, Essigsäure, Propionsäure, Butyrsäure, Hexansäure, Adipinsäure, Azelainsäure, Oxalsäure, Poly(acrylsäure), Poly(maleinsäure), Poly(methacrylsäure), und Copolymere von Carbonsäure und Kombinationen davon.

13. Das Verfahren nach einem der Ansprüche 1 bis 12, weiterhin Reagieren lassen der Mischung mit einem Dotierstoff umfassend mindestens eine Verbindung die ausgewählt ist aus der Gruppe bestehend aus Na, K, Li, Ca, I₂, (PF₆)⁻, (SbF₆)⁻, und FeCl₃.

14. Eine Zusammensetzung von Stoffen, umfassend:
Ein Polymer, das die folgende Struktur aufweist: 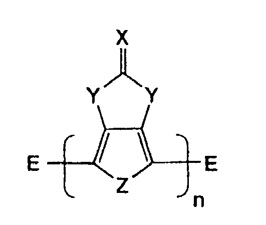
worin n eine ganze Zahl größer als 4 ist; worin Z mindestens ein Mitglied umfasst, das ausgewählt ist aus der Gruppe bestehend aus Se, S, O, NR₁, oder PR₁, worin R₁ Wasserstoff, Alkylaryl, Arylalkyl, oder Aryl ist; Y umfasst mindestens ein Mitglied, das unabhängig ausgewählt ist aus der Gruppe bestehend aus NH, O, C(R)₂, N(R)₂ und S; X ist unabhängig ausgewählt aus der Gruppe bestehend aus O, S, Se oder NH; E umfasst mindestens ein Mitglied, das unabhängig ausgewählt ist aus funktionellen oder nicht-funktionellen Endgruppen; und R umfasst mindestens ein Mitglied, das unabhängig ausgewählt ist aus der Gruppe bestehend aus substituierten oder unsubstituierten C₁-C₄-Alkylgruppen.

15. Die Zusammensetzung nach Anspruch 14, worin die Zusammensetzung eine wässrige Dispersion umfasst.

16. Die Zusammensetzung nach Anspruch 15, weiterhin ein Substrat umfassend.

17. Die Zusammensetzung nach Anspruch 16, worin das Substrat mindestens ein Material umfasst, das ausgewählt ist aus der Gruppe bestehend aus Glas, organischen Polymeren, Plastik, Silikon, Mineralien, Halbleitermaterialien, Keramiken, Metallen und Kombinationen daraus.

18. Die Zusammensetzung nach Anspruch 17, worin das Substrat und das Polymer mindestens ein Mittel bilden, das ausgewählt ist aus der Gruppe bestehend aus antistatisch beschichteten Substraten, einem elektrisch leitfähigen, beschichteten Substrat, einem elektrochromen Bauteil, einem photovoltaischem Bauteil, einer lichtemittierenden Elektrode, einem Flachbildschirm, einem photostrukturierbarem Schaltkreis, einem druckbaren Schaltkreis, einem Dünnfilm-Transistor-Bauteil, einer Batterie, einem elektrischen Schalter, einem beschichteten Kondensator, einem korrosionsbeständigen, beschichteten Substrat, einem Material zur elektromagnetischen Abschirmung, einem Sensor und anderen optoelektronischen Bauteilen.

19. Die Zusammensetzung nach Anspruch 18, worin das gebildete Polymer elektrische Eigenschaften umfasst.

20. Die Zusammensetzung nach Anspruch 19, worin die elektrischen Eigenschaften mindestens eine Eigenschaft umfassen, die ausgewählt ist aus der Gruppe bestehend aus elektrischer Leitfähigkeit, Halbleitereigenschaft, Elektrolumineszenz, Elektrochromie, photovolatischen Eigenschaften und Kombinationen daraus.

21. Die Zusammensetzung nach Anspruch 14, worin das Polymer weiterhin sich wiederholende Struktureinheiten umfasst, die die folgende Struktur haben: 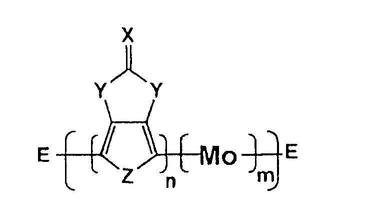 worin n und m unabhängig ausgewählt sind aus ganzen Zahlen, die eine Summe haben die größer als 4 ist und Z umfasst mindestens ein Mitglied, das ausgewählt ist aus der Gruppe bestehend aus Se, S, O, NR₁, oder PR₁, worin R₁ Wasserstoff, Alkylaryl, Arylalkyl, oder Aryl umfasst; Y umfasst mindestens ein Mitglied, das unabhängig ausgewählt ist aus der Gruppe bestehend aus NH, O, C(R)₂, N(R)₂ und S; X umfasst mindestens ein Mitglied das unabhängig ausgewählt ist aus der Gruppe bestehend aus O, S, Se oder NH; und E umfasst mindestens ein Mitglied, das unabhängig ausgewählt ist aus funktionellen oder nicht-funktionellen Endgruppen; R umfasst mindestens eine substituierten oder unsubstituierten C₁-C₄-Alkylgruppe und worin die n-Unterstruktureinheit und m-Unterstruktureinheit des Copolymers mindestens ein Mitglied umfasst, das ausgewählt ist aus der Gruppe bestehend aus Random-Copolymeren, Graft-Copolymeren, Block-Copolymeren und dentritischen Strukturen und Mo in der Struktur umfasst mindestens ein elektroaktives oder nichtelektroaktives Monomer das mit der n-Unterstruktureinheit polymerisierbar ist, umfassend mindestens ein Mitglied, das ausgewählt ist aus der Gruppe bestehend aus Thieno[3,4-b]thiophenen und substituierten Thiophenen.

22. Die Zusammensetzung nach Anspruch 14, worin das Polymer mindestens ein Homopolymer umfasst.

23. Die Zusammensetzung nach Anspruch 14, worin das Polymer mindestens ein BlockCopolymer umfasst.

24. Polymer, das polymerisierte Einheiten mit der folgende Struktur aufweist: 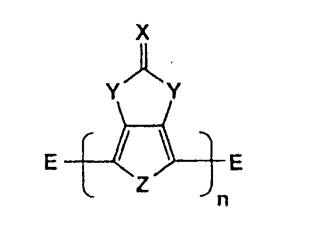 worin n eine ganze Zahl größer als 4 ist; Z umfasst mindestens ein Mitglied, das ausgewählt ist aus der Gruppe bestehend aus Se, S, O, NR₁, oder PR₁, worin R₁ Wasserstoff, Alkylaryl, Arylalkyl, oder Aryl; Y umfasst mindestens ein Mitglied, das unabhängig ausgewählt ist aus der Gruppe bestehend aus NH, O, C(R)₂, N(R)₂ und S; X ist unabhängig ausgewählt aus der Gruppe bestehend aus O, S, Se oder NH; E umfasst mindestens ein Mitglied, das unabhängig ausgewählt ist aus funktionellen oder nicht-funktionellen Endgruppen; und R umfasst mindestens ein Mitglied, das unabhängig ausgewählt ist aus der Gruppe bestehend aus substituierten oder unsubstituierten C₁-C₄-Alkylgruppen.

25. Die Zusammensetzung nach Anspruch 14, worin die wässrige Dispersion weiterhin mindestens ein Additiv umfasst, das ausgewählt ist aus der Gruppe bestehend aus partikelförmigem Kupfer, Silber, Nickel, Aluminium, Carbon Black, Talk, Glimmer, Wollastonit, Silica, Lehm, TiO₂, Farbstoffen, Pigmenten, und Kombinationen daraus.

26. Verfahren zur Erzeugung einer Polymerbeschichtung umfassend:
Bereitstellen einer wässrigen Dispersion umfassend
Ein Polymer, das die folgende Struktur aufweist: 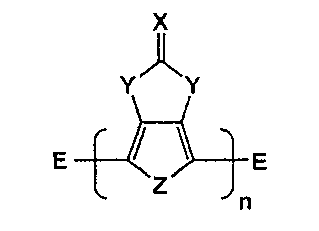 worin n 4 oder mehr ist; worin Z Se, S, O, NR₁, oder PR₁ ist, worin R₁ Wasserstoff, Alkylaryl, Arylalkyl, oder Aryl ist; Y ist unabhängig ausgewählt aus der Gruppe bestehend aus NH, O, C(R)₂, N(R)₂ und S; X ist unabhängig ausgewählt aus der Gruppe bestehend aus O, S, Se oder NH; E ist unabhängig ausgewählt aus funktionellen oder nicht-funktionellen Endgruppen; und R ist unabhängig ausgewählt aus der Gruppe bestehend aus substituierten oder unsubstituierten C₁-C₄-Alkylgruppen;
Aufbringen der wässrigen Dispersion auf ein Substrat; und
Trocknen der wässrigen Dispersion um eine elektrisch leitfähige Polymerbeschichtung zu erzeugen.

27. Das Verfahren nach Anspruch 26, worin das Aufbringen eine der folgenden Techniken zur Auftragung umfasst, die ausgewählt ist aus der Gruppe bestehend aus Tintenstrahldruck, Siebdruck, Rollenvordruck, Rotationsbeschichten, Meniskus- und Tauchbeschichtung, Sprühbeschichtung, Bürstenstreichen, Rakelbeschichtung, Vorhanggießverfahren und Kombinationen daraus.

28. Das Verfahren nach Anspruch 26, worin das Trocken das Evaporieren bei Raumtemperatur umfasst.

29. Das Verfahren nach Anspruch 26, worin das Trocknen das Erhitzen der wässrigen Dispersion umfasst.

30. Elektrolyt-Kondensator, umfassend:
Eine erste Schicht, umfassend mindestens ein oxidierbares Metall;
Eine zweite Schicht, umfassend mindestens ein Oxid des Metalls, das zumindest einen Teil der Oberfläche der ersten Schicht bedeckt; und
Eine dritte Schicht, umfassend mindestens ein Polymer, das zumindest einen Teil der Oberfläche der zweiten Schicht umfasst und die folgende Formel aufweist: 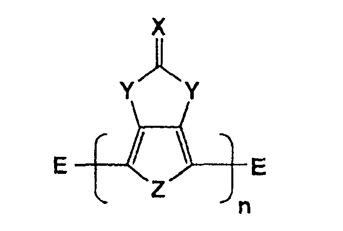 worin n 4 oder mehr ist; worin Z mindestens ein Mitglied umfasst, das ausgewählt ist aus der Gruppe bestehend aus Se, S, O, NR₁, oder PR₁, worin R₁ Wasserstoff, Alkylaryl, Arylalkyl, oder Aryl ist; Y umfasst mindestens ein Mitglied, das unabhängig ausgewählt ist aus der Gruppe bestehend aus NH, O, C(R)₂, N(R)₂ und S; X umfasst mindestens ein Mitglied, das unabhängig ausgewählt aus der Gruppe bestehend aus O, S, Se oder NH; E umfasst mindestens ein Mitglied, das unabhängig ausgewählt ist aus funktionellen oder nicht-funktionellen Endgruppen; und R umfasst mindestens ein Mitglied, das unabhängig ausgewählt ist aus der Gruppe bestehend aus substituierten oder unsubstituierten C₁-C₄-Alkylgruppen.

31. Der Kondensator nach Anspruch 30, worin das Metall mindestens ein Mitglied umfasst, das ausgewählt ist aus der Gruppe bestehend aus Aluminium, Niob und Tantal.

32. Der Kondensator nach Anspruch 30, weiter umfassend eine vierte Schicht, die zumindest einen Teil der Oberfläche der dritten Schicht bedeckt, umfassend ein leitfähiges Material.

33. Der Kondensator nach Anspruch 32, worin das leitfähige Material mindestens ein Mitglied umfasst, das ausgewählt ist aus der Gruppe bestehend aus Silber, Kupfer oder Carbon Black.

## Revendications

1. Procédé de formation d'un polymère électriquement conducteur, comprenant :
la fourniture d'un mélange comprenant :
un composant monomère ayant la structure suivante : 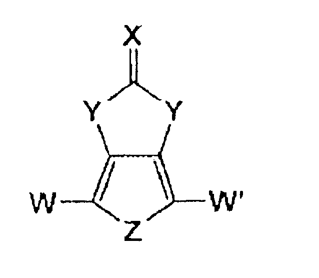 dans laquelle Z comprend au moins un élément choisi dans le groupe consistant en Sc, S, O, NR₁ ou PR₁, R₁ comprenant un atome d'hydrogène, un groupe alkylaryle, arylalkyle ou aryle ; Y comprend un élément choisi indépendamment dans le groupe consistant en NH, O, C(R)₂, N(R)₂ et S ; X comprend un élément choisi indépendamment dans le groupe consistant en O, S, Se ou NH ; W et W' sont choisis indépendamment dans le groupe consistant en H, les atomes d'halogène, les composés organométalliques, l'acide boronique, les esters boroniques, les motifs vinyle, -S-COR₄ et -COR₄ ; R comprend un élément choisi indépendamment dans le groupe consistant en les groupes alkyle en C₁ à C₄ substitués ou non substitués ; et R₄ comprend un élément choisi indépendamment dans le groupe consistant en H ou un groupe alkyle en C₁ à C₆, -C≡CH et les cycles aromatiques polymérisables ;
de l'eau ;
un polyanion ; et
un oxydant ;
la réaction du mélange pendant une durée suffisante et à une température suffisante pour produire un polymère ayant des propriétés électriquement conductrices.

2. Procédé de la revendication 1, dans lequel le mélange est maintenu à une température d'environ 0 °C à environ 100 °C.

3. Procède selon la revendication 1 ou 2, dans lequel le polyanion comprend au moins un anion choisi dans le groupe consistant en un anion d'un acide polyacrylique, d'un acide polyméthacrylique, d'un acide polysulfonique, d'un acide polymaléique, d'acide polystyrène-sulfonique, d'acide polyvinyl-sulfonique, de copolymères d'acide vinylcarboxylique avec un acrylate ou un styrène, d'acides vinylsulfoniques avec un acrylate ou un styrène et leurs combinaisons.

4. Procédé de l'une des revendications 1 à 3, dans lequel le polyanion comprend un poids moléculaire d'environ 1 000 à environ 500 000.

5. Procédé de formation d'un polymère électriquement conducteur, comprenant :
la fourniture d'un mélange comprenant :
un composant monomère ayant la structure suivante : 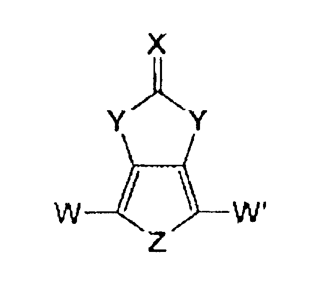 dans laquelle Z est Se, S, 0, NR₁ ou PR₁, R₁ étant un atome d'hydrogène, un groupe alkylaryle, arylalkyle ou aryle ; Y est choisi indépendamment dans le groupe consistant en NH, O, C(R)₂, N(R)₂ et S ; X est choisi indépendamment dans le groupe consistant en O, S, Se ou NH ; W et W' sont choisis indépendamment dans le groupe consistant en H, les atomes d'halogène, les composés organométalliques, l'acide boronique, les esters boroniques, les motifs vinyle, -S-COR₄ et -COR_{4 ;} R est choisi indépendamment dans le groupe consistant en les groupes alkyle en C₁ à C₄ substitués ou non substitués ; et R₄ est choisi indépendamment dans le groupe consistant en H ou un groupe alkyle en C₁ à C₆, -C≡CH et les cycles aromatiques polymérisables ;
un solvant ; et
un oxydant :
la réaction du mélange pendant une durée suffisante et à une température suffisante pour produire un polymère ayant des propriétés électriquement conductrices.

6. Procédé selon la revendication 5, dans lequel le mélange est maintenu à une température d'environ 20 °C à environ 250 °C.

7. Procédé de l'une quelconque des revendications 5 ou 6, dans lequel le solvant est choisi dans le groupe consistant en les alcools aliphatiques, les cétones aliphatiques, les esters carboxyliques aliphatiques, les hydrocarbures aromatiques, les hydrocarbures aliphatiques, les hydrocarbures chlorés, les nitriles aliphatiques, les sulfoxydes et sulfones aliphatiques, les carboxamides aliphatiques, les éthers aliphatiques et araliphatiques, les solutions aqueuses de ceux-ci et les combinaisons de ceux-ci.

8. Procédé de l'une quelconque des revendications 1 à 7, dans lequel on fait réagir le mélange pendant environ 5 minutes à environ 48 heures.

9. Procédé de l'une quelconque des revendications 1 à 8, dans lequel l'oxydant comprend au moins un composé choisi dans le groupe consistant en les sels de fer (III), H₂O₂, K₂Cr₂O₇, les persulfates alcalins, le persulfate d'ammonium, les perborates alcalins, le permanganate de potassium, les sels de cuivre, l'iode, l'air et l'oxygène.

10. Procédé de formation d'un polymère électriquement conducteur, comprenant :
la fourniture d'un mélange comprenant :
un composant monomère ayant la structure suivante : 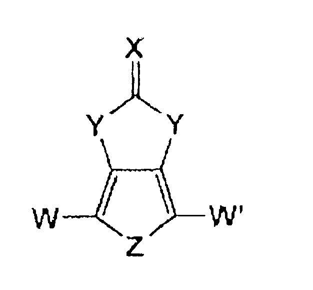 dans laquelle Z est Se, S, O, NR₁ ou PR₁, R₁ étant un atome d'hydrogène, un groupe alkylaryle, arylalkyle ou aryle ; Y est choisi indépendamment dans le groupe consistant en NH, O, C(R)₂, N(R)₂ et S ; X est choisi indépendamment dans le groupe consistant en O, S, Se ou NH ; W et W' sont choisis indépendamment dans le groupe consistant en H, les atomes d'halogène, les composés organométalliques, l'acide boronique, les esters boroniques, les motifs vinyle. -S-COR₄ et -COR₄ ; R est choisi indépendamment dans le groupe consistant en les groupes alkyle en C₁ à C₄ substitués ou non substitués ; et R₄ est choisi indépendamment dans le groupe consistant en H et un groupe alkyle en C₁ à C₆, -C≡CH et les cycles aromatiques polymérisables ;
un électrolyte ;
la mise en contact du mélange avec une cellule électrolytique ;
la fourniture d'un courant dans le mélange pour polymériser le monomère.

11. Procédé selon l'une quelconque des revendications 1 à 10, comprenant en outre l'application du mélange sur un substrat,
le substrat comprenant de préférence au moins un matériau choisi dans le groupe consistant en le verre, les polymères organiques, le plastique, le silicium, les minéraux, les matériaux semi-conducteurs, les céramiques, les métaux et leurs combinaisons.

12. Procédé selon l'une quelconque des revendications 1 à 11, comprenant en outre la réaction du mélange avec un dopant comprenant au moins un composé choisi dans le groupe consistant en HCl, HNO₃, H₂SO₄, H₃PO₄, HBr, HI, l'acide dodécyl-benzène sulfonique, l'acide laurylsulfonique, l'acide camphre-sulfonique, les colorants organiques acides, l'acide méthanesulfonique, l'acide toluènesulfonique, l'acide poly(styrène sulfonique), les copolymères d'acide sulfonique, l'acide acétique, l'acide propionique, l'acide butyrique, l'acide hexanoïque, l'acide adipique, l'acide azélaïque, l'acide oxalique, l'acide poly(acrylique), l'acide poly(maléique), l'acide poly(méthacrylique) et les copolymères d'acide carboxylique et leurs combinaisons.

13. Procédé selon l'une quelconque des revendications 1 à 12, comprenant en outre la réaction du mélange avec un dopant comprenant au moins un composé choisi dans le groupe consistant en Na, K, Li, Ca, I₂, (PF₆)⁻, (SbF₆)⁻ et FeCl₃.

14. Composition comprenant :
un polymère ayant la structure suivante : 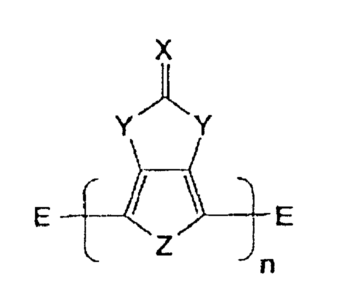
dans laquelle n est un nombre entier supérieur à 4 ; Z comprend au moins un élément choisi dans le groupe consistant en Se, S, O, NR₁ ou PR₁, R₁ étant un atome d'hydrogène, un groupe alkylaryle, arylalkyle ou aryle ; Y comprend au moins un élément choisi indépendamment dans le groupe consistant en NH, O, C(R)₂, N(R)₂ et S ; X est choisi indépendamment dans le groupe consistant en O, S, Se ou NH ; E comprend au moins un élément choisi indépendamment parmi les groupes terminaux fonctionnels ou non fonctionnels ; et R comprend au moins un élément choisi indépendamment dans le groupe consistant en des groupes alkyle en C₁ à C₄ substitués ou non substitués.

15. Composition de la revendication 14, où la composition comprend une dispersion aqueuse.

16. Composition de la revendication 15, comprenant en outre un substrat.

17. Composition de la revendication 16, dans laquelle le substrat comprend au moins un matériau choisi dans le groupe consistant en le verre, les polymères organiques, le plastique, le silicium, les minéraux, les matériaux semi-conducteurs, les céramiques, les métaux et leurs combinaisons.

18. Composition de la revendication 17, dans laquelle le substrat et le polymère forment au moins un dispositif choisi dans le groupe consistant en un substrat à revêtement antistatique, un substrat à revêtement électriquement conducteur, un dispositif électrochimique, un dispositif photovoltaïque, une diode électroluminescente, un écran plat, un circuit photosensible, un circuit imprimé, un dispositif de transistor à couches minces, une batterie, un commutateur électrique, un condensateur à revêtement, un substrat à revêtement anti-corrosion, un matériau formant écran électromagnétique, un capteur et autres dispositifs opto-électroniques.

19. Composition selon la revendication 18, dans laquelle le polymère formé a des propriétés électriques.

20. Composition selon la revendication 19, dans laquelle les propriétés électriques comprennent au moins une propriété choisie dans le groupe consistant en la conductivité électrique, la semi-conductivité, l'électroluminescence, l'électrochromie, les propriétés photovoltaïques et leurs combinaisons.

21. Composition selon la revendication 14, dans laquelle le polymère comprend en outre la répétition des motifs structuraux de structure suivante : 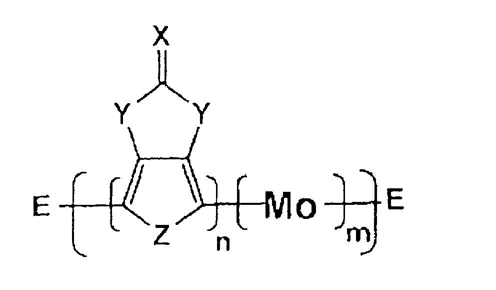 dans laquelle n et m sont des nombres entiers choisis indépendamment, ayant un total n + m supérieur à 4 et Z comprend au moins un élément choisi dans le groupe consistant en Se, S, O, NR₁ ou PR₁, R₁ comprenant un atome d'hydrogène, un groupe alkylaryle, arylalkyle ou aryle ; Y comprend au moins un élément choisi indépendamment dans le groupe consistant en NH, O, C(R)₂, N(R)₂ et S ; X comprend au moins un élément choisi indépendamment dans le groupe consistant en O, S, Se ou NH et E comprend au moins un élément choisi indépendamment parmi les groupes terminaux fonctionnels ou non fonctionnels ; R comprend au moins un groupe alkyle en C₁ à C₄ substitué ou non substitué et la sous-structure à motif n et la sous-structure à motif m du copolymère comprennent au moins un élément choisi dans le groupe consistant en les copolymères statistiques, les copolymères greffés, les copolymères à blocs et les structures dendritiques et Mo dans la structure, comprend au moins un monomère électro-actif ou non électro-actif copolymérisable, la sous-structure à motif n comprenant au moins un élément choisi dans le groupe consistant en les thiéno[3,4-b]thiophènes et les thiophènes substitués.

22. Composition de la revendication 14, dans laquelle le polymère comprend au moins un homopolymère.

23. Composition de la revendication 14, dans laquelle le polymère comprend au moins un copolymère à blocs.

24. Polymère ayant des motifs polymérisés de structure suivante : 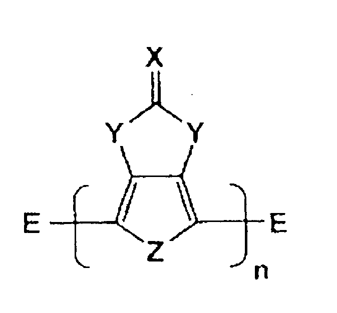 dans laquelle n est un nombre entier supérieur à 4 ; Z comprend au moins un élément choisi dans le groupe consistant en Se, S, O, NR₁ ou PR₁, R₁ étant un atome d'hydrogène, un groupe alkylaryle, arylalkyle ou aryle : Y comprend au moins un élément choisi indépendamment dans le groupe consistant en NH, O, C(R)₂, N(R)₂ et S ; X est choisi indépendamment dans le groupe consistant en O, S, Se ou NH ; E comprend au moins un élément choisi indépendamment parmi les groupes terminaux fonctionnels ou non fonctionnels et R comprend au moins un élément choisi indépendamment dans le groupe consistant en des groupes alkyle en C₁ à C₄ substitués ou non substitués.

25. Composition selon la revendication 14, dans laquelle la dispersion aqueuse comprend en outre au moins un additif choisi dans le groupe consistant en sous forme particulaire, le cuivre, l'argent, le nickel, l'aluminium, le noir de carbone, le talc, le mica, la wollastonite, la silice, l'argile, le TiO₂, des colorants, des pigments et leurs combinaisons.

26. Procédé de formation d'un revêtement polymère comprenant :
la fourniture d'une dispersion aqueuse comprenant
un polymère ayant la structure suivante : 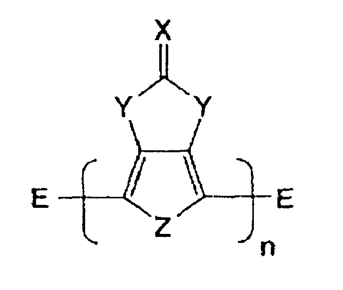 dans laquelle n vaut 4 ou plus ; Z est Se, S, O, NR₁ ou PR₁, R₁ étant un atome d'hydrogène, un groupe alkylaryle, arylalkyle ou aryle ; Y est choisi indépendamment dans le groupe consistant en NH, O, C(R)₂, N(R)₂ et S ; X est choisi indépendamment dans le groupe consistant en O, S, Se ou NH ; E est choisi indépendamment parmi les groupes terminaux fonctionnels ou non fonctionnels et R est choisi indépendamment dans le groupe consistant en des groupes alkyle en C₁ à C₄ substitués ou non substitués ;
l'application de la dispersion aqueuse sur un substrat ; et
le séchage de la dispersion aqueuse pour former un revêtement polymère électriquement conducteur.

27. Procédé de la revendication 26, dans lequel l'application comprend l'une des techniques d'application suivantes choisies dans le groupe consistant en l'impression à jet d'encre, la sérigraphie, l'impression au rouleau, le revêtement par centrifugation, le revêtement à ménisque et par dip ("dip coating"), le revêtement par pulvérisation, le revêtement à la brosse, l'application au couteau, le coulage par projection et leurs combinaisons.

28. Procédé de la revendication 26, dans lequel le séchage comprend l'évaporation à température ambiante.

29. Procédé de la revendication 26, dans lequel le séchage comprend le chauffage de la dispersion aqueuse.

30. Condensateur électrolytique comprenant :
une première couche comprenant au moins un métal oxydable ;
une deuxième couche comprenant au moins un oxyde du métal qui couvre au moins une partie d'une surface de la première couche ; et
une troisième couche comprenant au moins un polymère qui couvre au moins une partie d'une surface de la deuxième couche présentant la formule suivante : 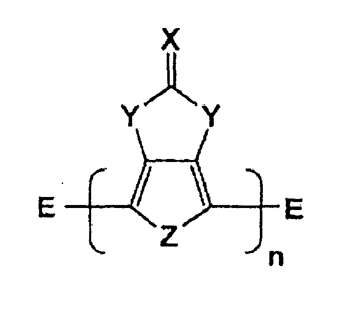
dans laquelle n vaut 4 ou plus ; Z comprend au moins un élément choisi dans le groupe consistant en Se, S, O, NR₁ ou PR₁, R₁ étant un atome d'hydrogène, un groupe alkylaryle, arylalkyle ou aryle ; Y comprend au moins un élément choisi indépendamment dans le groupe consistant en NH, O, C(R)₂, N(R)₂ et S ; X comprend au moins un élément choisi indépendamment dans le groupe consistant en O, S, Se ou NH ; E comprend au moins un élément choisi indépendamment parmi les groupes terminaux fonctionnels ou non fonctionnels et R comprend au moins un élément choisi indépendamment dans le groupe consistant en des groupes alkyle en C₁ à C₄ substitués ou non substitués.

31. Condensateur selon la revendication 30, dans lequel le métal comprend au moins un élément choisi dans le groupe consistant en l'aluminium, le niobium et le tantale.

32. Condensateur selon la revendication 30, comprenant en outre une quatrième couche qui couvre au moins une partie d'une surface de la troisième couche comprenant un matériau conducteur.

33. Condensateur selon la revendication 32, dans lequel le matériau conducteur comprend au moins un élément choisi dans le groupe consistant en l'argent, le cuivre et le noir de carbone.
